(19) Europäisches Patentamt / European Patent Office / Office européen des brevets

(11) **EP 2 535 392 B1**

(12) **EUROPEAN PATENT SPECIFICATION**

(45) Date of publication and mention
of the grant of the patent:
**03.09.2014 Bulletin 2014/36**

(51) Int Cl.:
*H05B 33/14* (2006.01)    *H01L 33/50* (2010.01)
*C09K 11/73* (2006.01)

(21) Application number: **12172725.9**

(22) Date of filing: **26.12.2011**

(54) **Halophosphate phosphor and white light-emitting device**

Halophosphatphosphor und Weißlicht-Ausgabevorrichtung

Phosphore d'halophosphate et dispositif émetteur de lumière blanche

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2011 JP 2011190112**
**25.02.2011 PCT/JP2011/054365**

(43) Date of publication of application:
**19.12.2012 Bulletin 2012/51**

(60) Divisional application:
**13194614.7 / 2 703 469**

(62) Document number(s) of the earlier application(s) in accordance with Art. 76 EPC:
**11824324.5 / 2 568 513**

(73) Proprietor: **Mitsubishi Chemical Corporation Tokyo 108-0014 (JP)**

(72) Inventors:
• **Sakuta, Hiroaki**
  **Mie, 510-0875 (JP)**
• **Kagawa, Kazuhiko**
  **Mie, 510-0875 (JP)**
• **Satou, Yoshihito**
  **Ibaraki, 300-1295 (JP)**
• **Seto, Takatoshi**
  **Ibaraki 305-0065 (JP)**
• **Kijima, Naoto**
  **Tokyo, 194-0031 (JP)**

(74) Representative: **HOFFMANN EITLE Patent- und Rechtsanwälte Arabellastrasse 4 81925 München (DE)**

(56) References cited:
**WO-A1-2009/141982    US-A1- 2010 322 275**
**US-A1- 2011 006 334**

**Description**

TECHNICAL FIELD

The present invention relates to a halophosphate phosphor, in particular to a blue (blue-green) phosphor that has sufficient emission intensity in the wavelength region around 490 nm and that has high emission luminance at a temperature region reached during LED operation. The present invention also relates to a phosphor conversion-type white light-emitting device in which light emitted by a semiconductor light-emitting element undergoes wavelength conversion by a phosphor to thereby generate white light, in particular a white light-emitting device that is suitable for illumination applications.

BACKGROUND ART

Halophosphate phosphors activated by divalent $Eu^{2+}$ are ordinarily useful as phosphors in fluorescent lamps relying on mercury-vapor resonance-line excitation at 254 nm, and have been widely used, in particular, as blue to blue-green light-emitting components in fluorescent lamps that use mixtures of various types of phosphor.

Numerous light-emitting devices in which the emission color of LEDs or LDs is converted by phosphors have been proposed in recent years. For instance, JP-A-2004-253747 (Patent document 1) describes $(Sr,Ba,Ca)_5(PO_4)_3Cl:Eu^{2+}$ as a phosphor that emits blue light when receiving irradiation of light in the 350 to 415 nm region from an LED, and indicates that, in particular, large emission intensity can be achieved through irradiation with illumination light around 400 nm if the content of Eu, as an activator, is high.

As described above, numerous studies are being conducted on the use of white light-emitting devices in which the emission color of an LED is converted by a phosphor, as backlight light sources in liquid crystal display devices or the like. For instance, WO 2009/141982 (Patent document 2) describes $(Sr_{1-x-y-z}Ba_xCa_yEu_z)_5(PO_4)_3Cl$, which is the above-mentioned halophosphate phosphor, as a blue phosphor that emits blue light when irradiated with light in the 330 to 410 nm region from an LED, and indicates that reducing the values of x and y to within a predetermined range has the effect of narrowing the spectral width of light from a powder of the blue phosphor, so that the phosphor is suitable for uses in backlights.

Red phosphors of high luminance and good durability and which comprise nitride or oxynitride backbones have been disclosed in recent years, for instance $CaAlSiN_3$: Eu (hereafter also "CASN phosphor" for short) disclosed in JP-A-2006-008721 (Patent document 3), $(Sr,Ca)AlSiN_3$: Eu (hereafter also "SCASN phosphor" for short) disclosed in JP-A-2008-7751 (Patent document 4) and $Ca_{1-x}Al_{1-x}Si_{1+x}N_{3-x}O_x$: Eu (hereafter also "CASON phosphor" for short) disclosed in JP-A-2007-231245 (Patent document 5).

Thus, the influence exerted by the characteristics of the blue phosphor and the green phosphor on the performance of the white light-emitting device are relatively reinforced through attainment of high luminance by the red phosphor. In particular, the luminance and stability of the white light-emitting device are directly influenced by the luminance and stability of the green phosphor that emits light in a wavelength region of high luminosity factor.

At present, the green phosphor of highest luminance is an Eu-activated alkaline earth silicate phosphor, represented by $(Ba,Ca,Sr,Mg)_2SiO_4$: Eu, described in, for instance, WO 2007-091687 (Patent document 6). As indicated in the above patent documents, those phosphors having a comparatively narrow emission band width (half width smaller than 70 nm) and having an emission peak wavelength ranging from 520 to 530 nm, from among the above-mentioned phosphors, exhibit extremely high emission efficiency. However, the temperature characteristics and durability of Eu-activated alkaline earth silicate phosphors are not necessarily good. Therefore, attention has been focused on green phosphors having an oxynitride backbone, as green phosphors having superior stability, for instance $Si_{6-z}Al_zN_{s-z}O_z$: Eu (hereafter also "β-SiAlON phosphor" for short) disclosed in, for instance, JP-A-2005-255895 (Patent document 7), and $M_3Si_6O_{12}N_2$: Eu (wherein M is an alkaline earth metal element, hereafter referred also to as "BSON phosphor" for short) disclosed in WO 2007-088966 (Patent document 8).

Examples of blue phosphors include, for instance, $Sr_5(PO_4)_3Cl:Eu^{2+}$ disclosed in document 1 described above, and $BaMgAl_{10}O_{17}$:Eu (hereafter also "BAM phosphor" for short) disclosed in JP-A-2004-266201 (Patent document 9).

Patent document 1: JP-A-2004-253747
Patent document 2: WO 2009/141982
Patent document 3: JP-A-2006-008721
Patent document 4: JP-A-2008-007751
Patent document 5: JP-A-2007-231245
Patent document 6: WO 2007/091687
Patent document 7: JP-A-2005-255895

Patent document 8: WO 2007/088966
Patent document 9: JP-A-2004-266201

SUMMARY OF THE INVENTION

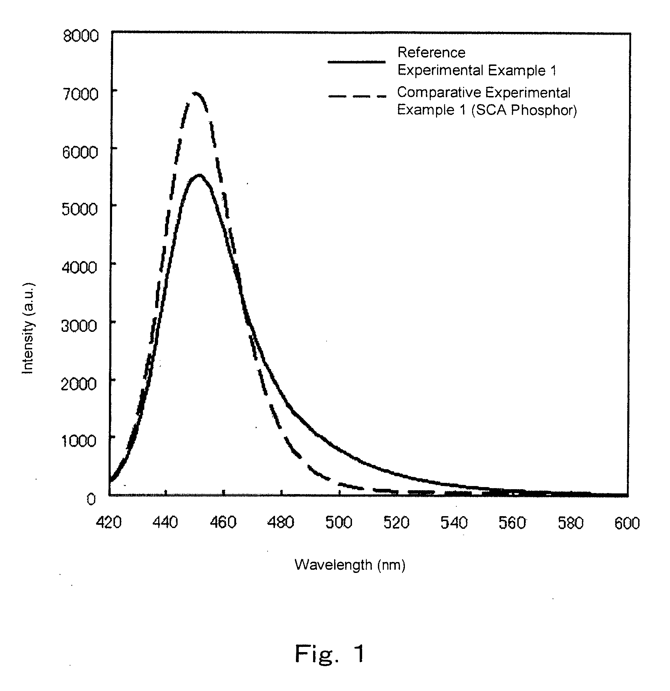

The inventors studied the emission spectrum of the halophosphate phosphor $Sr_{4.5}Eu_{0.5}(PO_4)_3Cl$ (hereafter also "SCA phosphor" for short), as a blue phosphor for LEDs, and found that the emission luminance of the phosphor was low because the half width value of the emission peak was small and emission intensity in the wavelength region around 490 nm was insufficient (Fig. 1).

Therefore, in the case of a light-emitting device that combines a first luminous body such as a near-ultraviolet LED or the like with a second luminous body that contains the SCA phosphor, the emission spectrum of the light-emitting device exhibited a large valley in the wavelength region around 490 nm. The emission intensity at that valley was insufficient, and hence the light-emitting device was problematic in terms of poor color rendering properties and low emission luminance.

The temperature characteristics of the emission luminance of the SCA phosphor were studied, and it was found that luminance was very low at 100°C, which is a temperature region reached during LED operation.

Therefore, a light-emitting device that combines a first luminous body such as a near-ultraviolet LED or the like with a second luminous body that contains the SCA phosphor was handicapped by a first problem in that emission luminance and color rendering properties in the light-emitting device worsened when the temperature of the device rose as a result of prolonged use.

Eu-activated oxynitride green phosphors such as the above-described β-SiAlON phosphor and BSON phosphor exhibit superior durability compared with Eu-activated alkaline earth silicate phosphors, but are not yet a match of the latter in terms of luminance. A conceivable means for increasing the luminance of such Eu-activated oxynitride green phosphor would involve setting the emission peak wavelength to 535 nm or greater to increase thereby the emission intensity at a wavelength region of high luminosity factor (around 555 nm).

The inventors produced trial white LEDs using a green phosphor in the form of the β-SiAlON phosphor (commercialized product) having an emission peak wavelength of 540 nm, as an oxynitride green phosphor having the luminance thereof increased as a result of the above-described means. An InGaN-based near-ultraviolet LED having an emission peak wavelength at 406 nm was used as the excitation light source, a BAM phosphor was used as the blue phosphor, and a CASON phosphor was used as the red phosphor. The measured color rendering properties of the obtained white LED revealed a good value, exceeding 90, of general color rendering index Ra, but a special color rendering index R12, which is an index of bright blue reproducibility, of about 80, which was an unsatisfactory value in terms of achieving high color rendering illumination.

Therefore, a second problem arose in that bright blue reproducibility must be improved in order to enable a white light-emitting device that uses a high-luminance green phosphor having an emission peak wavelength of 535 nm or greater to be suitably used in high color rendering illumination.

In a first aspect of the present invention aimed at solving the first problem, a first object is to provide a blue (blue-green) phosphor that has sufficient emission intensity in the wavelength region around 490 nm and that has high emission luminance at a temperature region reached during LED operation.

In a second aspect of the present invention aimed at solving the second problem, a second object is to provide a white light-emitting device, having improved bright blue reproducibility, that uses a high-luminance green phosphor having an emission peak wavelength of 535 nm or greater.

As a result of diligent research aimed at solving the first problem, the inventors found that it is possible to obtain a phosphor that has sufficient emission intensity in the wavelength region around 490 nm and that has high emission luminance at a temperature region reached during LED operation, by way of a phosphor used in a light-emitting device that has a first luminous body that emits light of 350 to 430 nm and a second luminous body that emits visible light as a result of being irradiated with light from the first luminous body, the phosphor being used by being incorporated into the second luminous body and having a chemical composition represented by general formula [1'] below, such that in the phosphor the ratio of intensity at the wavelength 490 nm with respect to the intensity of the emission peak wavelength is a given value, and arrived at the present invention on the basis of that finding.

$$Sr_aBa_bEu_x(PO_4)_cX_d \qquad\qquad [1']$$

(In general formula [1'], X is Cl; c, d and x are numbers satisfying $2.7 \leq c \leq 3.3$, $0.9 \leq d \leq 1.1$ and $0.3 \leq x \leq 1.2$; and a and b satisfy the conditions $a+b = 5-x$ and $0.12 \leq b/(a+b) \leq 0.4$.)

Herein, a, b, x, c and d denote, respectively, the mole ratio of Sr, the mole ratio of Ba, the mole ratio of Eu, the mole ratio of the $PO_4$ group, and the mole ratio of the anion group X. For instance, a composition $Eu_{0.5}Sr_{3.825}Ba_{0.675}(PO_4)_3Cl$ implies a = 3.825, b = 0.675, x = 0.5, c = 3, d = 1, and hence falls within the above formula [1].

As a result of diligent research aimed at solving the second problem, the inventors found that a white light-emitting device having excellent bright blue reproducibility can be obtained by using a halophosphate phosphor having sufficient emission intensity at a wavelength region around 490 nm, as a blue phosphor that is used together with a high-luminance green phosphor having an emission peak wavelength of 535 nm or greater, and by virtue of the feature wherein light emitted by the light-emitting device has a deviation duv of -0.0200 to 0.0200 from a black body radiation locus, and has a color temperature ranging from 1800 K to 7000 K, and arrived at the present invention on the basis of that finding.

Therefore, a first mode of the present invention is summarized in features (1) to (6) below.

(1) A phosphor, used in a light-emitting device that has a first luminous body that emits light of 350 to 430 nm and a second luminous body that emits visible light as a result of being irradiated with light from the first luminous body, the phosphor being used by being incorporated into the second luminous body,

wherein the phosphor has a chemical composition represented by general formula [1'] below, and

an I (490 nm) /I (peak) value, in which I(peak) denotes an intensity of an emission peak wavelength and I (490 nm) denotes an intensity at wavelength 490 nm in an emission spectrum of the phosphor upon excitation with light of wavelength 410 nm, satisfies formula [2] below:

$$\mathrm{Sr}_a\mathrm{Ba}_b\mathrm{Eu}_x\,(\mathrm{PO}_4)_c\mathrm{X}_d \qquad\qquad [1']$$

(In general formula [1'], X is Cl; c, d and x are numbers satisfying $2.7 \leq c \leq 3.3$, $0.9 \leq d \leq 1.1$ and $0.3 \leq x \leq 1.2$; and a and b satisfy the conditions a+b = 5-x and $0.12 \leq b/(a+b) \leq 0.4$),

$$0.2 \leq \mathrm{I}(490\ \mathrm{nm})/\mathrm{I}(\mathrm{peak}) \qquad\qquad [2].$$

(2) The phosphor according to (1), wherein a value I (100°C)/I(room temperature), in which I (100°C) denotes an intensity of an emission peak wavelength in an emission spectrum obtained by excitation with light of wavelength 410 nm at a temperature of 100°C, and I (room temperature) denotes an intensity of an emission peak wavelength in an emission spectrum obtained by excitation with light of wavelength 410 nm at room temperature, satisfies formula [4] below:

$$0.68 \leq \mathrm{I}(100°\mathrm{C})/\mathrm{I}(\mathrm{room\ temperature}) \qquad\qquad [4].$$

(3) A light-emitting device having a first luminous body that emits light of 350 to 430 nm, and a second luminous body that emits visible light as a result of being irradiated with light from the first luminous body, wherein the second luminous body comprises the phosphor according to (1) or (2) as a first phosphor, and the light emitted by the light-emitting device has a deviation duv of -0.0200 to 0.0200 from a black body radiation locus, and a color temperature ranging from 1800 K to 7000 K.

(4) The light-emitting device according to (3), wherein the second luminous body further has a second phosphor, and the second phosphor contains at least one type of phosphor having a different emission peak wavelength from that of the first phosphor.

(5) The light-emitting device according to (3) or (4), wherein the light emitted by the light-emitting device is a mixture of light from the first luminous body and light from the second luminous body, and is white.

(6) An illumination device, having the light-emitting device according to any one of (3) to (5).

A second mode of the present invention is summarized in features (7) to (14) below.

(7) A white light-emitting device of a phosphor conversion-type which has a semiconductor light-emitting element that emits light in the near-ultraviolet wavelength region, and a phosphor, and in which white light is emitted through wavelength conversion, by the phosphor, of light emitted by the semiconductor light-emitting element, wherein the phosphor includes a blue phosphor having a chemical composition of formula [1] below, a green phosphor having an emission peak wavelength of 535 nm or greater, and at least one type of red phosphor selected from among an Eu-activated nitride phosphor and an Eu-activated oxynitride phosphor, and

white light emitted by the white light-emitting device has a color temperature ranging from 1800 K to 7000 K:

$$(\mathrm{Sr},\ \mathrm{Ca})_a\mathrm{Ba}_b\mathrm{Eu}_x(\mathrm{PO}_4)_c\mathrm{X}_d \qquad\qquad [1]$$

(In general formula [1], X is Cl; c, d and x are numbers satisfying $2.7 \leq c \leq 3.3$, $0.9 \leq d \leq 1.1$ and $0.3 \leq x \leq 1.2$; and a and b satisfy the conditions $a+b = 5-x$ and $0.12 \leq b/(a+b) \leq 0.4$.).

Herein, a, b, x, c and d denote, respectively, the mole ratio of Sr, the mole ratio of Ba, the mole ratio of Eu, the mole ratio of the $PO_4$ group, and the mole ratio of the anion group X. For instance, a composition $Eu_{0.5}Sr_{3.825}Ba_{0.675}(PO_4)_3Cl$ implies a = 3.825, b = 0.675, x = 0.5, c = 3, d = 1, and hence falls within the above formula [1].

(8) The white light-emitting device according to (7), wherein the light color of the white light emitted by the white light-emitting device has a deviation duv of -0.0200 to 0.0200 from a black body radiation locus.

(9) The white light-emitting device according to (7) or (8), wherein the green phosphor has an emission peak wavelength ranging from 535 to 545 nm and an emission peak half width ranging from 55 to 70 nm, the blue phosphor has an emission peak wavelength ranging from 450 to 460 nm, and an I (490 nm) /I (peak) value, in which I(peak) denotes an intensity of the emission peak wavelength and I (490 nm) denotes an intensity at wavelength 490 nm in an emission spectrum of the blue phosphor upon excitation with light of wavelength 410 nm, ranges from 0.55 to 0.65.

(10) The white light-emitting device according to any one of (7) to (9), wherein the green phosphor has an emission peak wavelength ranging from 535 to 545 nm and an emission peak half width ranging from 55 to 70 nm, and, in the blue phosphor, a metal element among elements that make up the phosphor is substantially Sr, Eu and Ba alone, and the b/(a+b) value in general formula [1] ranges from 0.15 to 0.20.

(11) The white light-emitting device according to any one of (7) to (10), wherein the green phosphor includes an Eu-activated oxynitride phosphor.

(12) The white light-emitting device according to any one of (7) to (11), wherein the red phosphor includes a CASON phosphor.

(13) The white light-emitting device according to any one of (7) to (12), wherein a general color rendering index Ra and a special color rendering index R12 are both 90 or greater.

(14) The white light-emitting device according to (7), wherein the green phosphor is an Eu-activated oxynitride phosphor, and a metal element among elements that make up the blue phosphor is substantially Sr, Eu and Ba alone, and the b/(a+b) value in formula [1] ranges from 0.16 to 0.4.

(15) The white light-emitting device according to (14), wherein the value of x in formula [1] ranges from 0.3 to less than 0.65.

(16) The white light-emitting device according to any one of (7) to (15), wherein the blue phosphor, the green phosphor and the red phosphor are dispersed in a light-transmitting resin material and are encapsulated thereafter in the white light-emitting device, such that a ratio of a sedimentation rate of the blue phosphor in the light-transmitting resin material with respect to that of the green phosphor ranges from 0.70 to 1.30.

(17) The white light-emitting device according to any one of (7) to (16), wherein the blue phosphor, the green phosphor and the red phosphor are dispersed in a light-transmitting resin material and are encapsulated thereafter in the white light-emitting device, such that a ratio of a sedimentation rate of the red phosphor in the light-transmitting resin material with respect to that of the green phosphor ranges from 0.70 to 1.30.

(18) The white light-emitting device according to any one of (7) to (17), wherein densities of the blue phosphor, the green phosphor and the red phosphor range all from 3.0 to 5.0 $g/cm^3$.

(19) The white light-emitting device according to any one of (7) to (18), wherein the phosphor forms a phosphor layer, and a distance between the phosphor layer and the semiconductor light-emitting element ranges from 0.1 to 500 mm.

(20) The white light-emitting device according to (19), wherein a condensing lens is provided on a light exit surface side of the phosphor layer.

(21) The white light-emitting device according to (19), wherein a light extraction layer is provided on a light exit surface side of the phosphor layer.

(22) A blue phosphor having a chemical composition of formula represented by general formula [1].

$$(Sr,Ca)_a Ba_b Eu_x (PO_4)_c X_d \qquad [1]$$

(In general formula [1], X is Cl; c, d and x are numbers satisfying $2.7 \leq c \leq 3.3$, $0.9 \leq d \leq 1.1$ and $0.3 \leq x \leq 1.2$; and a and b satisfy the conditions $a+b = 5-x$ and $0.12 \leq b/(a+b) \leq 0.4$.)

(23) The blue phosphor according to (22), wherein a half width of the emission peak upon excitation at 410 nm ranges from 40 to 82 nm.

(24) The blue phosphor according to (22) or (23), wherein the emission peak wavelength upon excitation at 410 nm ranges from 451 to 474 nm.

Effect of the invention

A first mode of the present invention provides a blue (blue-green) phosphor that has sufficient emission intensity in the wavelength region around 490 nm and that has high emission luminance at a temperature region reached during LED operation.

A second mode of the present invention provides a white light-emitting device having excellent bright blue reproducibility and that uses a high-luminance green phosphor having an emission peak wavelength of 535 nm or greater.

## BRIEF DESCRIPTION OF THE DRAWINGS

Fig. 1 is a set of emission spectra of a phosphor of Reference experimental example 1 and a phosphor (SCA phosphor) of Comparative experimental example 1;

Fig. 2 is a graph illustrating emission luminance at 80°C, 100°C and 130°C of the phosphors of Experimental example 3, Experimental examples 7 to 12 and Comparative experimental example 5;

Fig. 3 is an emission spectrum of a white LED according to Experimental example 15;

Fig. 4 is an emission spectrum of a white LED according to Comparative experimental example 8;

Fig. 5 is an emission spectrum of a white LED according to Experimental example 19;

Fig. 6 is an emission spectrum of a white LED according to Experimental example 20;

Fig. 7 is an emission spectrum of a white LED according to Experimental example 21;

Fig. 8 is a conceptual diagram illustrating an embodiment of a white light-emitting device of the present invention;

Fig. 9 is a conceptual diagram illustrating an embodiment of a white light-emitting device of the present invention;

Fig. 10 is a conceptual diagram illustrating an embodiment of a phosphor layer used in a white light-emitting device of the present invention;

Fig. 11 is a conceptual diagram illustrating an embodiment of a phosphor layer used in a white light-emitting device of the present invention;

Fig. 12 is a conceptual diagram illustrating an embodiment of a white light-emitting device of the present invention;

Fig. 13 is a set of conceptual diagrams illustrating various embodiments of a white light-emitting device of the present invention;

Fig. 14 is a conceptual diagram illustrating one form of a light-transmitting substrate of a phosphor layer that is used in a white light-emitting device of the present invention;

Fig. 15 is a conceptual diagram illustrating one form of a light-transmitting substrate of a phosphor layer that is used in a white light-emitting device of the present invention;

Fig. 16 is a conceptual diagram illustrating one form of a light-transmitting substrate of a phosphor layer that is used in a white light-emitting device of the present invention;

Fig. 17 is a conceptual diagram illustrating one form of a light-transmitting substrate of a phosphor layer that is used in a white light-emitting device of the present invention;

Fig. 18 is a conceptual diagram illustrating one form of a light-transmitting substrate of a phosphor layer that is used in a white light-emitting device of the present invention; and

Fig. 19 is a conceptual diagram illustrating one form of a light-transmitting substrate of a phosphor layer that is used in a white light-emitting device of the present invention.

## BEST MODE FOR CARRYING OUT THE INVENTION

Embodiments and examples of the present invention are explained below, but the present invention is not limited to any of the embodiments and examples, and may be modified in various ways without departing from the scope of the invention.

In the present description, numerical value ranges defined by "... to ..." are ranges that include the lower limit value and upper limit value denoted by the numerical values that appear before and after "to", respectively. The relationships between color tone and chromaticity coordinate in the present description are all based on JIS Standards (JIS Z 8110).

Composition formulas of phosphors in the present description are separated from each other by a comma plus space (, ). . In enumerations of a plurality of elements separated by commas (,), one, two or more of the listed elements may be present in arbitrary combinations and compositions. For instance, a composition formula " $(Ba, Sr, Ca) Al_2O_4:$ Eu" encompasses collectively, "$BaAl_2O_4:Eu$", "$SrAl_2O_4:Eu$", "$CaAl_2O_4:Eu$", "$Ba_{1-x}Sr_xAl_2O_4: Eu$", "$Ba_{1-x}Ca_xAl_2O_4: Eu$", "$Sr_{1-x}Ca_xAl_2o_4:Eu$" and "$Ba_{1-x-y}Sr_xCa_yAl_2O_4:Eu$" (in the formulas, $0 < x < 1$, $0 < y < 1$ and $0 < x+y < 1$).

The term phosphor in the present description denotes phosphors at least part whereof has a crystal structure.

In the present description, the half width of the emission peak of the phosphors denotes the full width at half maximum of the emission peak in the emission spectrum.

1. Halophosphate phosphor

A first mode of the present invention is a phosphor (hereafter also referred to as "phosphor according to the first aspect" for short). The phosphor according to the first aspect is a phosphor used in a light-emitting device that has a first luminous body that emits light of 350 to 430 nm and a second luminous body that emits visible light as a result of being irradiated with light from the first luminous body, the phosphor being used by being incorporated into the second luminous body, and having a chemical composition represented by general formula [1] below:

$$(Sr, Ca)_a Ba_b Eu_x (PO_4)_c X_d \qquad [1]$$

(In general formula [1], X is Cl; c, d and x are numbers satisfying $2.7 \leq c \leq 3.3$, $0.9 \leq d \leq 1.1$ and $0.3 \leq x \leq 1.2$; and a and b satisfy the conditions $a+b = 5-x$ and $0.12 \leq b/(a+b) \leq 0.4$.)

The phosphor may contain elements other than the above-mentioned ones, so long as the effect of the present invention is not significantly impaired thereby.

Also, the phosphor may contain other components, for instance a light-scattering substance, in an amount that does not impair the performance of the phosphor.

The phosphor of general formula [1] will be explained next. In terms of, for instance, emission characteristics, temperature characteristics and so forth, the phosphor of formula [1] comprises specific amounts of Sr, Ca and Ba. Specifically, a mole ratio a of Sr and Ca and a mole ratio b of Ba satisfy the conditions $a+b = 5-x$ and $b/(a+b)$ value ranging from 0.12 to 0.4. The $b/(a+b)$ value is preferably 0.20 or greater, and more preferably, 0.28 or greater. In particular, the half width of the emission peak of the emission spectrum increases abruptly, which is advantageous, when the $b/(a+b)$ value is 0.16 or greater. Also, the $b/(a+b)$ value is preferably 0.40 or smaller, more preferably 0.34 or smaller. The luminance value drops if the $b/(a+b)$ value is excessively small, while an excessive $b/(a+b)$ value may result in excessive overlap of the emission spectra of the phosphor and of a green phosphor, which makes high emitting device harder to achieve, in a case where the former phosphor is combined with a green phosphor and a red phosphor in a light-emitting device.

Preferably, the content of Ca with reference to the content of Sr is 5 mol% or greater, more preferably 10 mol% or greater.

The halophosphate phosphor according to the first aspect may contain one element from among Sr and Ca, or may contain both Sr and Ca, as indicated by general formula [1]. In order to increase emission intensity at the wavelength 490 nm of the emission spectrum, or in order to increase luminance retention at high temperature, the halophosphate phosphor has preferably a chemical composition represented by general formula [1'] in which only Sr is contained from among Sr and Ca:

$$Sr_a Ba_b Eu_x (PO_4)_c X_d \qquad [1']$$

(In general formula [1'], X is Cl; c, d and x are numbers satisfying $2.7 \leq c \leq 3.3$, $0.9 \leq d \leq 1.1$, $0.3 \leq x \leq 1.0$; and a and b satisfy the conditions $a+b = 5-x$ and $0.12 \leq b/(a+b) \leq 0.4$.)

In formulas [1] and [1'], part of the Sr may be substituted by a metal element other than Eu, Sr, Ca and Ba. Examples of the metal element include, for instance, Mg, Zn and Mn. Most preferred among the foregoing is Mg, from the viewpoint of luminance. The substitution amount is preferably 5 mol% or greater, more preferably 10 mol% or greater with respect to Sr. If the substitution amount is too small, luminance may fail to be sufficiently high at the temperature of LED operation.

No particular restriction is imposed on metal elements that may be incorporated, as the metal element, other than the above-listed metal elements. Preferably, however, there are incorporated metal elements having the same valence as Sr, namely divalent metal elements, since crystal growth is promoted thereby. From the viewpoint of the spread of the ionic radius of the elements that can be used, and the likelihood of favoring crystal formation, there may be introduced small amounts of monovalent, trivalent, tetravalent, pentavalent, hexavalent or the like metal elements. In one example, part of the $Sr^{2+}$ in the phosphor can be substituted with $Na^+$ and $La^{3+}$ while preserving a charge compensation effect. Part of Sr can also be replaced by small amounts of metal elements that can act as sensitizers.

The anion group X in general formulas [1] and [1'] is Cl. However, it should be apparent to a person skilled in the art that part of X may be replaced by an anion group other than Cl, in an amount that does not impair the effect of the present invention. If part of the anion group X is replaced by an anion group other than Cl, the amount of the anion group other than Cl is preferably 50 mol% or smaller, more preferably 30 mol% or smaller, particularly preferably 10 mol% or smaller, and most preferably 5 mol% or smaller.

From the viewpoint of luminance at a temperature reached during LED operation and so forth, the mole ratio x of Eu in general formulas [1] and [1'] is ordinarily $x \geq 0.3$, preferably $x \geq 0.35$, more preferably $x \geq 0.4$, yet more preferably $x \geq 0.45$, and most preferably, in particular, $x \geq 0.5$. Too small a mole ratio x of the luminescent center Eu tends to result in low emission intensity. An excessively high x value tends to result in reduced emission luminance on account of the phenomenon known as concentration quenching. Therefore, x is ordinarily set to $x \leq 1.2$, preferably $x \leq 1.0$, more preferably $x \leq 0.9$, particularly preferably $x \leq 0.8$, yet more preferably $x \leq 0.7$, even yet more preferably $x \leq 0.65$, and most preferably $x \leq 0.55$.

In the phosphor according to the first aspect, at least part of the activator Eu is present in the form of a divalent cation. Although the activator Eu can have divalent or trivalent valence, the proportion of divalent cations is preferably high. Specifically, the proportion of $Eu^{2+}$ with respect to the total Eu amount is ordinarily 80 mol% or greater, preferably 85 mol% or greater, more preferably 90 mol% or greater, particularly preferably 95 mol% or greater, and is most preferably 100 mol%.

The activator Eu may be replaced by at least one metal element selected from the group consisting of Ce, Tb, Sb, Pr, Er and Mn, as other activators. The activator Eu may be replaced by one type alone from among the foregoing metal elements, or may be concomitantly replaced by arbitrary combinations, in arbitrary ratios, of two or more types of the foregoing metal elements.

In general formulas [1] and [1'], c and d satisfy $2.7 \leq c \leq 3.3$, $0.9 \leq d \leq 1.1$, but c is preferably $2.8 \leq c \leq 3.2$, more preferably $2.9 \leq c \leq 3.1$, and d is preferably $0.93 \leq d \leq 1.07$, more preferably $0.95 \leq d \leq 1.05$.

2. Physical properties of the halophosphate phosphor

2-1. Form of the halophosphate phosphor

Ordinarily the phosphor according to the first aspect is in the form of microparticles. Specifically, the phosphor according to the first aspect is microparticles whose volume median diameter $D_{50}$ is ordinarily 50 $\mu$m or smaller, preferably 30 $\mu$m or smaller, and ordinarily 2 $\mu$m or greater, preferably 5 $\mu$m or greater. If the volume median diameter $D_{50}$ is excessive, for instance, the microparticles tend to disperse poorly in a resin used as a below-described encapsulating material. Too small a volume median diameter $D_{50}$ tends to result in low luminance.

The volume median diameter $D_{50}$ is a value obtained on the basis of a volume-basis particle size distribution curve that is obtained by measuring a particle size distribution by laser diffraction/scattering. The median diameter $D_{50}$ denotes the particle size value for the 50% cumulative value in the volume-basis particle size distribution curve.

2-2. Emission color of the halophosphate phosphor

The phosphor according to the first aspect emits ordinarily blue to blue-green light. That is, the phosphor according to the first aspect is ordinarily a blue to blue-green phosphor.

The chromaticity coordinates of the fluorescence of the phosphor according to the first aspect are ordinarily coordinates within a region demarcated by $(x,y) = (0.10,0.06)$, $(0.10,0.36)$, $(0.20,0.06)$ and $(0.20,0.36)$; preferably, coordinates within a region demarcated by $(x,y) = (0.13, 0.09)$, $(0.13,0.30)$, $(0.18,0.09)$ and $(0.18,0.30)$; more preferably, coordinates within a region demarcated by $(x,y) = (0.13, 0.09)$, $(0.13,0.26)$, $(0.18,0.09)$ and $(0.18, 0.26)$. Accordingly, the chromaticity coordinate x from among the chromaticity coordinates of the fluorescence of the phosphor according to the first aspect is ordinarily 0.10 or greater, preferably 0.13 or greater, and ordinarily 0.20 or smaller, preferably 0.18 or smaller. The chromaticity coordinate y is ordinarily 0.06 or greater, preferably 0.09 or greater, and ordinarily 0.36 or smaller, preferably 0.30 or smaller, more preferably 0.26 or smaller.

The fluorescence chromaticity coordinates can be calculated on the basis of below-described emission spectra. The values of the above-described chromaticity coordinates x,y are chromaticity coordinate values in the CIE coordinate system, for emission color upon excitation by light of wavelength 410 nm.

2-3. Emission characteristics of the halophosphate phosphor

Given that the phosphor according to the first aspect is used as a blue to blue-green phosphor, the fluorescence spectrum (emission spectrum) of the phosphor according to the first aspect exhibits, upon excitation with light of wavelength 410 nm, an emission peak wavelength that is ordinarily 440 nm or greater, preferably 450 nm or greater, more preferably 451 nm or greater, yet more preferably 455 nm or greater, and particularly preferably 460 nm or greater; and ordinarily smaller than 490 nm, preferably 480 nm or smaller, more preferably 475 nm or smaller, and yet more preferably 474 nm or smaller. Preferred emission characteristics can be brought out, in particular, in combination with a $\beta$-SiAlON phosphor in a case where the peak wavelength ranges from 451 to 474 nm.

The half width (full width at half maximum, also "FWHM" hereafter) of the emission peak of the phosphor according to the first aspect when excited with light of wavelength 410 nm is ordinarily of 35 nm or greater, preferably 40 nm or greater, more preferably 50 nm or greater, and in particular 70 nm or greater. Widening thus the half width affords good luminance in the light-emitting device in a case where the latter combines a first luminous body, such as an LED or the like, with a second luminous body that contains the above-described phosphor. The upper limit of the half width of the emission peak is not restricted, but is ordinarily set to 90 nm or less, preferably 82 nm or less. Preferred emission characteristics can be brought out, in particular, in combination with a β-SiAlON phosphor in a case where the peak wavelength ranges from 40 to 82 nm.

The phosphor according to the first aspect has ordinarily sufficient emission intensity at a wavelength region around 490 nm, in an emission spectrum upon excitation with light of wavelength 410 nm. Specifically, an I (490 nm) /I (peak) value satisfies formula [2] below, where I (peak) denotes the intensity of the emission peak wavelength and I (490 nm) denotes the intensity at the wavelength 490 nm. Herein, the intensity of the emission peak wavelength denotes the emission intensity at the wavelength of the peak top of the emission peak.

$$0.2 \leq I(490 \ nm)/I(peak) \qquad [2]$$

The left-side value of formula [2] is 0.2, but is preferably 0.3, more preferably 0.4, in particular 0.5, and most preferably 0.8. That is, the 1(490 nm) /I (peak) value is preferably 0.2 or greater, more preferably 0.3 or greater, yet more preferably 0.4 or greater, particularly preferably 0.5 or greater, and most preferably 0.8 or greater.

The 1(490 nm) /I (peak) value characterizes the shape of the emission spectrum, such that a greater value translates into a greater value of emission intensity at 490 nm. Therefore, the value of emission intensity in a wavelength region around 490 nm decreases when the I (490 nm) /I (peak) value drops below the above-mentioned range. As a result, the emission spectrum of the light-emitting device may exhibit a large valley at the wavelength region around 490 nm in a case where the light-emitting device combines a first luminous body, such as an LED or the like, with a second luminous body that contains the above-described phosphor. An emission shortfall in such a valley may result in a light-emitting device having impaired luminance.

The emission spectrum can be measured using a fluorescence measurement apparatus (by JASCO Corporation) equipped with a multichannel CCD detector C7041 (by Hamamatsu Photonics K. K.) as a spectrometer, and using a 150 W xenon lamp as an excitation light source, at room temperature, for instance 25°C.

More specifically, light from the excitation light source is caused to pass through a diffraction grating spectroscope at a focal distance of 10 cm, and only excitation light of wavelength 410 nm is irradiated onto a phosphor, via an optical fiber. The light generated by the phosphor as a result of irradiation of excitation light is split by a diffraction grating spectroscope at a focal distance of 25 cm, the emission intensity of each wavelength is measured by a spectrometer at a wavelength range from 300 nm to 800 nm, and the results are subjected to signal processing, for instance, sensitivity correction, in a personal computer, to yield an emission spectrum. Measurements are performed by setting the slit width of the light-receiving side spectroscope to 1 nm.

2-4. Luminance of the halophosphate phosphor

The phosphor according to the first aspect has ordinarily high emission luminance at room temperature. In the present description, luminance denotes a value resulting from integrating, over the entire wavelength region, the value luminosity factor x emission intensity at each wavelength.

The proportion of the relative luminance of the phosphor according to the first aspect with respect to the luminance of the SCA phosphor $[Eu_{0.5}Sr_{4.5} (PO_4)_3Cl]$ produced in accordance with the same method as that of the phosphor of the present invention is ordinarily 130% or greater, preferably 160% or greater, more preferably 210% or greater, and yet more preferably 300% or greater. In the case of a below-described blue phosphor (I), a phosphor wherein the b/(a+b) value in general formula [1] or [1'] is 0.16 or greater exhibits a significantly asymmetrical peak shape in the emission spectrum, and also a long wavelength side that is considerably broader than the short wavelength side of the peak wavelength. Luminance becomes very high as a result.

2-5. Excitation characteristics of the halophosphate phosphor

The wavelength of the light that excites the phosphor according to the first aspect (excitation wavelength) varies depending on the composition and so forth of the phosphor according to the first aspect, but ordinarily, the excitation wavelength is 350 nm or greater, preferably 380 nm or greater, more preferably 405 nm or greater, and ordinarily 430 nm or smaller, preferably 420 nm or smaller, more preferably 415 nm or smaller.

2-6. Temperature characteristics of the intensity in the emission peak wavelength of the halophosphate phosphor

The phosphor according to the first aspect exhibits ordinarily temperature characteristics that are superior to those of the SCA phosphor [$Eu_{0.5}Sr_{4.5}(PO_4)_3Cl$] produced according to an identical method. Specifically, the value I (80°C)/I(room temperature), wherein I (room temperature) is the intensity of the emission peak wavelength in the emission spectrum obtained by exciting the phosphor with light of wavelength 410 nm at room temperature (about 20°C) and I (80°C) is the intensity of the emission peak wavelength in the emission spectrum obtained by exciting the phosphor with light of wavelength 410 nm at a temperature of 80°C, preferably satisfies formula [3] below.

$$0.75 \leq I(80°C)/I(room\ temperature) \qquad [3]$$

The value on the left side of formula [3] is ordinarily 0.75, but is preferably 0.80, more preferably 0.85, in particular 0.87, and is the more preferable the closer the value is to 1. That is, the value of I (80°C) /I (room temperature) is preferably 0.75 or greater, more preferably 0.80 or greater, yet more preferably 0.85 or greater, particularly preferably 0.87 or greater, and is the more preferable the closer the value is to 1. The upper limit value of I (80°C)/I(room temperature) is ordinarily 1.

Preferably, the value of I (100°C)/I(room temperature), wherein I (100°C) denotes the intensity of the emission peak wavelength in the emission spectrum upon excitation with light of wavelength 410 nm at a temperature of 100°C satisfies formula [4] below.

$$0.68 \leq I(100°C)/I(room\ temperature) \qquad [4]$$

The value on the left side of formula [4] is ordinarily 0.68, but is preferably 0.70, more preferably 0.72, particularly preferably 0.80, most preferably 0.83, and is the more preferable the closer the value is to 1. That is, the value of I (100°C)/I(room temperature) is preferably 0.68 or greater, more preferably 0.70 or greater, yet more preferably 0.72 or greater, particularly preferably 0.80 or greater, most preferably 0.83, and is the more preferable the closer the value is to 1. The upper limit value of I (100°C)/I(room temperature) is ordinarily 1.

In a below-described blue phosphor (I) in particular, formulas [3] and [4] can be satisfied by a phosphor wherein the metal elements among the constituent elements of the phosphors are essentially Sr, Eu and Ba alone, and the phosphor has a b/(a+b) value of 0. 16 or greater in general formula [1]. (Herein, the feature "metal elements among the constituent elements are essentially Sr, Eu and Ba alone" does not mean that the phosphor contains absolutely no metal element other than Sr, Eu and Ba; the presence of other elements whose intrusion is unavoidable in a production process or the like is allowable. For instance, the metal element may be a metal element present, as an unavoidable impurity, in the starting material of the phosphor, or a metal element comprised in the vessel (crucible) used during a firing process, such that the metal element intrudes into the phosphor out of the aforementioned vessel during firing.)

Preferably, the value of I (130°C)/I(room temperature), wherein I (130°C) denotes the intensity of the emission peak wavelength in the emission spectrum upon excitation with light of wavelength 410 nm at a temperature of 130°C, which is a typical operation temperature of high-output LEDs, satisfies formula [5] below.

$$0.60 \leq I(130°C)/I(room\ temperature) \qquad [5]$$

The value on the left side of formula [5] is ordinarily 0.60, preferably 0.67, more preferably 0.70, and is the more preferable the closer the value is to 1. That is, the value of I (130°C)/I(room temperature) is preferably 0.60 or greater, more preferably 0.65 or greater, yet more preferably 0.70 or greater, and is the more preferable the closer the value is to 1. The upper limit value of I (130°C)/I(room temperature) is ordinarily 1.

The temperature characteristics can be measured, for instance, using a MCPD7000 multi-channel spectrometer (by Otsuka Electronics Co. Ltd,.), and provided with a device that comprises a luminance colorimeter BM5A, as a luminance measurement device, a cooling mechanism based on a Peltier element, and a heating mechanism relying on a heater, and a 150 W xenon lamp as a light source. A cell holding a phosphor sample is placed on a stage, and the temperature is changed step-wise over 20°C, 25°C, 50°C, 75°C, 100°C, 125°C, 150°C and 175°C, and the surface temperature of the phosphor is checked. Next, the phosphor is excited with light of wavelength 410 nm that is extracted, split by a diffraction grating, out of the light source, and the luminance value and the emission spectrum are measured. The emission peak intensity is worked out from the measured emission spectrum. Herein, the value used as the measurement value of the surface temperature of the phosphor, on the side of excitation through being irradiated with light, is a value corrected by temperature measurement values from a radiation thermometer and a thermocouple.

A white light-emitting device can be provided that has excellent temperature characteristics by producing a below-described white light-emitting device according to a second aspect, by using concomitantly a blue phosphor according to the first aspect having good temperature characteristics, such as the above-described ones, together with an Eu-activated oxynitride green phosphor having good temperature characteristics and an Eu-activated nitride red phosphor or Eu-activated oxynitride red phosphor having good temperature characteristics.

The temperature characteristics of the blue phosphor according to the first aspect tend to become poorer in cases where the b/(a+b) value in general formula [1] is 0.1 or smaller, cases where the x value is 0.95 or greater, and cases where the phosphor substantially contains Ca. The temperature between 80°C to 100°C is the envisaged temperature of the blue phosphor upon operation of a white light-emitting device according to a second aspect. In white light-emitting devices used for ordinary illumination, large currents, of 500 mA or greater, are sometimes applied onto excitation LEDs having a chip size of 1 mm$^2$. The temperature of the phosphor can reach 100°C in such cases.

2.7 Temperature characteristics of the emission luminance of the halophosphate phosphor

The proportion of relative luminance at 80°C, which is a temperature reached during LED operation, of the phosphor according to the first aspect, with respect to the luminance of the SCA phosphor [$Eu_{0.5}Sr_{4.5}(PO_4)_3Cl$] produced ordinarily in accordance with the same method as that of the phosphor according to the first aspect, is ordinarily 150% or greater, preferably 180% or greater, more preferably 250% or greater, yet more preferably 300% or greater, and particularly preferably 400% or greater.

Also, the proportion of the relative luminance at 100°C, which is a temperature reached during LED operation, of the phosphor of the present invention, with respect to the luminance of an $Eu_{0.5}Sr_{4.5}(PO_4)_3Cl$ phosphor, as the SCA phosphor, manufactured in accordance with the same method as that of the phosphor of the present invention, is ordinarily 150% or greater, preferably 173% or greater, more preferably 250% or greater, yet more preferably 300% or greater, and particularly preferably 400% or greater. In particular, in the case where the metal elements among the constituent elements are essentially Sr, Eu and Ba alone, and the phosphor has a b/ (a+b) value of 0.16 or greater in general formula [1], the proportion of relative luminance of a phosphor with respect to the luminance at room temperature of the SCA phosphor can be 300% or greater at 80°C, and 250% or greater at 100°C.

Preferably, the proportion of relative luminance at 130°C, which is a typical temperature reached during operation of an LED power chip, of the phosphor according to the first aspect, with respect to the luminance of the SCA phosphor [$Eu_{0.5}Sr_{4.5}(PO_4)_3Cl$] produced ordinarily in accordance with the same method as that of the phosphor according to the first aspect, is ordinarily 150% or greater, preferably 155% or greater, more preferably 250% or greater, yet more preferably 300% or greater, and particularly preferably 400% or greater.

3. Production method of the halophosphate phosphor

The method for producing the phosphor according to the first aspect is not particularly limited, and any method may be used so long as the effect of the present invention is not significantly impaired thereby. However, the phosphor can ordinarily exhibit the above-described characteristics if the phosphor represented by formula [1] is produced in accordance with the production method explained below (hereafter also referred to as "production method of the present invention").

In the production method of the present invention, the phosphor of the present invention can be produced by firing a mixture of phosphor starting materials prepared so as to yield a composition represented by formula [1]. Ordinarily, metal compounds are used as the phosphor starting materials. Specifically, starting-material metal compounds are weighed so as to yield a predetermined composition, are mixed, and are fired thereafter, to produce the phosphor. For instance, the phosphor represented by formula [1] above can be produced by mixing (mixing step) necessary combinations out of a Sr starting material (hereafter also referred to as "Sr source"), a Ba starting material (hereafter also referred to as "Ba source"), an Eu starting material (hereafter also referred to as "Eu source") , a $PO_4$ starting material (hereafter also referred to as "$PO_4$ source") and an X starting material (hereafter also referred to as "X source"); and by firing the obtained mixture (firing step).

3-1. Phosphor starting materials

Examples of the phosphor starting materials used in the production of the phosphor according to the first aspect (i.e. the Sr source, Ba source, Eu source, $PO_4$ source and X source) include, for instance, an oxide, hydroxide, carbonate, nitrate, sulfate, oxalate, carboxylate or halide, or hydrates of the foregoing, of the various elements, namely Sr, Ba, Eu, $PO_4$ and X. Compounds from among the above may be appropriately selected in consideration of, for instance, reactivity with complex oxynitrides and little generation of $NO_x$, $SO_x$ and so forth upon firing.

(Sr source)

Specific examples of the Sr source follow below.

Specific examples of the Sr starting material (hereafter also referred to as "Sr source") include, for instance, an oxide such as SrO, a hydroxide such as $Sr(OH)_2 \cdot 8H_2O$, a carbonate such as $SrCO_3$, a nitrate such as $Sr(NO_3)_2 \cdot 4H_2O$, a sulfate such as $SrSO_4$, an oxalate such as $Sr(OCO)_2 \cdot H_2O$ or $Sr(C_2O_4) \cdot H_2O$, a carboxylate such as $Sr(OCOCH_3)_2 \cdot 0.5H_2O$, a halide such as $SrCl_2$ or $SrCl_2 \cdot 6H_2O$, and a nitride such as $Sr_3N_2$ or SrNH. Preferred among the foregoing is $SrCO_3$, since the latter has good stability in air, decomposes easily through heating, does not readily leave unintended residual elements, and a high-purity starting material is easy to procure. If a carbonate is used as the starting material, then the carbonate calcined beforehand may be utilized as the starting material.

(Ba source)

Specific examples of the Ba source follow below.

Specific examples of the Ba starting material (hereafter also referred to as "Ba source") include, for instance, an oxide such as BaO, a hydroxide such as $Ba(OH)_2 \cdot 8H_2O$, a carbonate such as $BaCO_3$, a nitrate such as $Ba(NO_3)_2$, a sulfate such as $BaSO_4$, a carboxylate such as $Ba(OCO)_2 \cdot H_2O$ or $Ba(OCOCH_3)_2$, a halide such as $BaCl_2$ or $BaCl_2 \cdot 6H_2O$, or a nitride such as $Ba_3N_2$ or BaNH. For instance, a carbonate or an oxide is preferably used among the foregoing. A carbonate is more preferable in terms of handling, since oxides react readily with moisture in air. Preferred among the foregoing is $BaCO_3$, since the latter has good stability in air and decomposes easily when heated, and therefore does not readily leave unintended residual elements; also, a high-purity starting material is easy to procure. If a carbonate is used as the starting material, then the carbonate calcined beforehand may be utilized as the starting material.

(Mg source, Ca source, Zn source and Mn source)

Specific examples of starting materials of Mg, Ca, Zn and Mn (hereafter also referred to as "Mg source, Ca source, Zn source and Mn source ") that may replace part of Sr include, for instance, the below-listed respective examples.

Specific examples of an Mg starting material (hereafter also referred to as "Mg source") include, for instance, an oxide such as MgO, a hydroxide such as $Mg(OH)_2$, a carbonate such as basic magnesium carbonate ($mMgCO_3 \cdot Mg(OH_2) \cdot nH_2O$), a nitrate such as $Mg(NO_3)_2 \cdot 6H_2O$, a sulfate such as $MgSO_4$, a carboxylate such as $Mg(OCO)_2 \cdot H_2O$ or $Mg(OCOCH_3)_2 \cdot 4H_2O$, a halide such as $MgCl_2$, a nitride such as $Mg_3N_2$ or a nitride such as MgNH. Preferred among the foregoing is MgO or basic magnesium carbonate. If a carbonate is used as the starting material, then the carbonate calcined beforehand may be utilized as the starting material.

Specific examples of the Ca starting material (hereafter also referred to as "Ca source") include, for instance, an oxide such as CaO, a hydroxide such as $Ca(OH)_2$, a carbonate such as $CaCO_3$, a nitrate such as $Ca(NO_3)_2 \cdot 4H_2O$, a sulfate such as $CaSO_4 \cdot 2H_2O$, a carboxylate such as $Ca(OCO)_2 \cdot H_2O$ or $Ca(OCOCH_3)_2 \cdot H_2O$, a halide such as $CaCl_2$, or a nitride such as $Ca_3N_2$, or CaNH. Preferred among the foregoing are, for instance, $CaCO_3$ and $CaCl_2$. If a carbonate is used as the starting material, then the carbonate calcined beforehand may be utilized as the starting material.

Specific examples of the Zn starting material (hereafter also referred to as "Zn source") include, among others, zinc compounds (which may be hydrated), for instance an oxide such as ZnO, a halide such as $ZnF_2$ or $ZnCl_2$, a hydroxide such as $Zn(OH)_2$, a nitride such as $Zn_3N_2$ or ZnNH, a carbonate such as $ZnCO_3$, a nitrate such as $Zn(NO_3)_2 \cdot 6H_2O$, a carboxylate such as $Zn(OCO)_2$ or $Zn(OCOCH_3)_2$, or a sulfate such as $ZnSO_4$. Preferred among the foregoing is $ZnF_2 \cdot 4H_2O$ (which may be in anhydrous form) from the viewpoint of the high particle growth promoting effect afforded thereby. If a carbonate is used as the starting material, then the carbonate calcined beforehand may be utilized as the starting material.

Specific examples of the Mn starting material (hereafter also referred to as "Mn source") include, for instance, an oxide such as $MnO_2$, $Mn_2O_3$, $Mn_3O_4$ or MnO, a hydroxide such as $Mn(OH)_2$, a peroxide such as MnOOH, a carbonate such as $MnCO_3$, a nitrate such as $Mn(NO_3)_2$, a carboxylate such as $Mn(OCOCH_3)_2 \cdot 2H_2O$ or $Mn(OCOCH_3)_3 \cdot nH_2O$, or a halide such as $MnCl_2 \cdot 4H_2O$. For instance, a carbonate or an oxide is preferably used among the foregoing. A carbonate is more preferable in terms of handling, since oxides react readily with moisture in air. Preferred among the foregoing is $MnCO_3$, since the latter has good stability in air and decomposes easily when heated, and therefore does not readily leave unintended residual elements; also, a high-purity starting material is easy to procure. If a carbonate is used as the starting material, then the carbonate calcined beforehand may be utilized as the starting material.

($PO_4$ source)

Specific examples of the $PO_4$ source follow below.

Specific examples of the $PO_4$ starting material (hereafter also referred to as "$PO_4$ source") include, for instance, a hydrogen phosphate, phosphate, metaphosphate or pyrophosphate of Sr, Ba $NH_4$ or the like, an oxide such as $P_2O_5$, as well as $PX_3$, $PX_5$, $Sr_2PO_4X$, $Ba_2PO_4X$, phosphoric acid, metaphosphoric acid, pyrophosphoric acid or the like.

(X source)

Specific examples of the X source follow below.
Specific examples of the X starting material (hereafter also referred to as "X source") include, for instance, SrX, BaX, $NH_4X$, HX, $Sr_2PO_4X$ and $Ba_2PO_4X$. The X source is selected from among the foregoing in consideration of, for instance, chemical composition, reactivity, and non-emission of $NO_x$, $SO_x$ and so forth during firing.

(Eu source)

Specific examples of the Eu source follow below.
Specific examples of the Eu starting material (hereafter also referred to as "Eu source") include, for instance, an oxide such as $Eu_2O_3$, a sulfate such as $Eu_2(SO_4)_3$, a oxalate such as $Eu_2(C_2O_4)_3 \cdot 10H_2O$, a halide such as $EuCl_2$, $EuCl_3$ or $EuCl_3 \cdot 6H_2O$, a carboxylic acid such as Eu $(OCOCH_3)_3 \cdot 4H_2O$, a nitrate such as $Eu_2(OCO)_3 \cdot 6H_2O$ or Eu $(NO_3)_3 \cdot 6H_2O$, or a nitride such as EuN or EuNH. Preferred among the foregoing are $Eu_2O_3$ and $EuCl_3$, in particular $Eu_2O_3$.
In each of the above-described Sr source, Ba source, Mg source, Ca source, Zn source, Mn source, $PO_4$ source, X source and Eu source there may be used one type alone, or two or more types used concomitantly in arbitrary combinations and ratios.

3-2. Phosphor production method: mixing step

Each phosphor starting material was weighed to a predetermined ratio, so as to obtain a phosphor described by the chemical composition of formula [1], and the starting materials were thoroughly mixed using a ball mill or the like, to yield a starting material mixture (mixing step).
The mixing method is not particularly limited, but the below-described methods (A) and (B) may specifically be used.

(A) Dry mixing method in which the above-described phosphor starting materials are crushed and mixed by combining crushing using for instance a dry crusher such as a hammer mill, a roll mill, a ball mill or a jet mill, or mortar and pestle, and mixing using a mixer such as a ribbon blender, a V blender, a Henschel mixer, or using a mortar and pestle.
(B) Wet mixing method in which a solvent such as water or a dispersion medium is added to the above-described phosphor starting materials, and the whole is mixed using, for instance, a crusher, mortar and pestle, an evaporating dish or a stirring bar, to yield a solution or slurry that is then dried by spray drying, heating drying, natural drying or the like.

The phosphor starting materials may be mixed using the aforementioned wet mixing method or dry mixing method, but a wet manufacturing method using water or ethanol is more preferable.

3-3. Phosphor production method: firing step

The phosphor of the present invention can be produced by firing, through a heating treatment, the prepared starting material mixture.
The specific operational procedure during firing is not limited, and ordinarily involves filling the starting material mixture obtained in the mixing step into a firing vessel made up of alumina, and firing then the firing vessel. The firing vessel that is used is not limited to an alumina crucible, and there may be used a heat-resistant vessel such as a crucible or tray made up of a material having low reactivity towards the phosphor starting materials. Besides alumina, specific examples of the material of the firing vessel include, for instance, ceramics such as quartz, boron nitride, silicon nitride, silicon carbide, magnesium or mullite, as well as carbon (graphite). Herein, quartz heat-resistant vessels can be used for thermal treatments at comparatively low temperatures, i.e. up to 1200°C. A preferred use temperature range is up to 1000°C.
As the firing atmosphere during firing there is selected an atmosphere that is necessary for obtaining the ionic state (valence) at which the elements of the luminescent center ions contribute to light emission. Provided that the phosphor of the present invention can be obtained, the firing atmosphere may be any atmosphere, but is ordinarily a reducing atmosphere. From the viewpoint of emission intensity, preferably, the valence of the activating elements comprised in the phosphor is predominantly divalent. Firing under a reducing atmosphere is preferable since Eu, which is in the form of $Eu^{3+}$ in the phosphor starting material, is reduced to $Eu^{2+}$.

Specific examples of the gas that can be used in the reducing atmosphere (hereafter, "reducing gas") include, for instance, hydrogen and carbon monoxide. These gases may be used singly but are ordinarily used mixed with an inert gas. Examples of inert gas include, for instance, nitrogen, argon and the like, but hydrogen-containing nitrogen gas is preferably used in practical terms.

In an environment of mixed inert gas and reducing gas, the proportion (mole ratio) of the reducing gas with respect to the total gas is ordinarily 0.5% or greater, preferably 2% or greater, more preferably 3% or greater. Below such ranges, the fired product obtained through firing may fail to be sufficiently reduced.

The reducing gas and the inert gas may be used each as one type alone, or may be used as two or more types in appropriate combinations and ratios.

It is possible to select conditions even under an oxidizing atmosphere such as atmospheric air or oxygen.

The firing temperature (highest reached temperature) is ordinarily 700°C or higher, preferably 900°C or higher, and ordinarily 1500°C or lower, preferably 1350°C or lower. If the firing temperature is lower than the above ranges, a carbonate used as a phosphor starting material may fail to undergo oxidative decomposition. On the other hand, a firing temperature above the above ranges may cause phosphor particles to fuse together, giving rise to coarse particles.

The temperature rise rate is ordinarily 1°C/minute or higher, and ordinarily 40°C/minute or lower. A temperature rise rate below the above range may result in a longer firing time. On the other hand, a temperature rise rate above the above range may result in damage to the firing apparatus, vessel and so forth. The temperature drop rate is ordinarily 1°C/minute or higher, and ordinarily 100°C/minute or lower. Industrial efficiency is poor if the temperature drop rate is below the above range. On the other hand, a temperature drop rate above the above range may exert a negative impact on the furnace.

The firing time varies depending on the temperature, pressure and so forth during firing, but is ordinarily 1 hour or longer, and ordinarily 24 hours or less.

The pressure during firing varies depending on the firing temperature and so forth, but is ordinarily 0.04 MPa or higher, and ordinarily 0.1 MPa or lower. From the viewpoint of industrial cost and labor, pressure is preferably close to atmospheric pressure.

The phosphor of the present invention can be obtained by subjecting the fired product obtained through the above-described firing step to, for instance, the belbw-described post-treatment.

As disclosed in JP-A-2009-30042 (paragraphs [0133] to [0149]), a phosphor may be produced through multi-stage firing in which two or more firing steps are performed (primary firing, secondary firing and so forth). For instance, a fired product can be grown, to increase particle size and yield a phosphor having high emission efficiency, by repeating, over a plurality of times, primary firing in an oxidizing atmosphere, and secondary firing in a reducing atmosphere.

Ordinarily, good single particles can be grown, in the above-described firing step, through the presence of a flux in the reaction system. In a case where the phosphor is produced through multi-stage firing that includes two or more firing steps, the effect elicited by adding the flux is brought out adequately from the second stage onwards.

3-4. Phosphor production method: post-treatment

Besides the abovementioned process, other processes may be performed in the production method of the present invention, as the case may require. For instance, the above-described firing step may be followed, as the case may require, by a crushing step, a washing step, a sorting step, a surface treatment step, a drying step and so forth.

4. Halophosphate phosphor-containing composition

In a case where the phosphor according to the first aspect is used in a light-emitting device or the like, the phosphor according to the first aspect is ordinarily used dispersed in a light-transmitting material, i.e. is used in the form of a phosphor-containing composition.

As the light-transmitting material in a composition containing the phosphor of the present invention there can be selected any material, in accordance with, for instance, the intended purpose, so long as the material can appropriately disperse the phosphor of the present invention and does not undergo undesirable reactions or the like. Examples of such a light-transmitting material include, for instance, silicone resins, epoxy resins, polyvinyl resins, polyethylene resins, polypropylene resins, polyester resins and the like.

These light-transmitting materials may be used a one type alone, or may be concomitantly used as two or more types in arbitrary combinations and ratios. The light-transmitting material may contain an organic solvent.

Besides the phosphor of the present invention and the light-transmitting material, the phosphor-containing composition may contain other arbitrary components, in accordance with, for instance, the intended application. Examples of other components include, for instance, spreading agents, thickeners, fillers, interference agents and the like. Specific examples include, for instance, silica fine powders such as aeorsil, as well as alumina. Such other components may be used as one type alone, or may be concomitantly used as two more types in arbitrary combinations and ratios.

5. Light-emitting device using the halophosphate phosphor

An explanation follows next on a light-emitting device that uses the halophosphate phosphor according to the first aspect.

The light-emitting device that uses a halophosphate phosphor according to the first aspect has a first luminous body that emits light of 350 to 430 nm, and a second luminous body that emits visible light as a result of being irradiated with light from the first luminous body, wherein the second luminous body contains, as a first phosphor, the halophosphate phosphor according to the first aspect.

5-1. First luminous body

The first luminous body emits light of a wavelength from 350 to 430 nm. The first luminous body emits light having a peak wavelength at 400 nm or greater, more preferably at 405 nm or greater, yet more preferably at 407 nm or greater, and also, preferably at 425 nm or smaller, more preferably at 415 nm or smaller, and yet more preferably at 413 nm or smaller. In particular, there is preferably used a GaN-based LED having a peak wavelength of 407 nm or greater, on account of the high emission efficiency afforded thereby.

As the first luminous body there can be used, ordinarily, a semiconductor light-emitting element, specifically a light-emitting diode (LED) or a semiconductor laser diode (hereafter also referred to as "LD" for short).

Preferred among the foregoing is a GaN-based LED or LD that uses a GaN-based compound semiconductor as the first luminous body. Particularly preferred among GaN-based LEDs are those having an $In_XGa_YN$ light-emitting layer, on account of the very strong emission intensity afforded by the latter. The emission peak wavelength of LEDs can be shifted towards longer wavelengths by increasing the value of X in an LED having an $In_XGa_YN$ light-emitting layer, as disclosed in document JP-A-6-260681. Particularly preferred among GaN-based LDs are those having a multiple quantum well structure of $In_XGa_YN$ layers and GaN layers, on account of the very strong emission intensity afforded thereby.

The value of X+Y above ranges ordinarily from 0.8 to 1.2. In terms of regulation of emission characteristics, preferred GaN-based LEDs are those in which the light-emitting layers are doped with Zn and/or Si, or are dopant-less.

A GaN-based LED has, as basic constituent elements, any of the above light-emitting layers, a p-layer, an n-layer, electrodes, and a substrate. GaN-based LEDs having a heterostructure in which the light-emitting layer is sandwiched between n-type and p-type $Al_XGa_YN$ layers, GaN layers, $In_XGa_YN$ layers or the like are preferred on account of the high emission efficiency of such LEDs. More preferably, the heterostructure is a quantum well structure, on account of the yet higher emission efficiency afforded thereby.

Known LEDs and LDs can be used as the above-mentioned LEDs and LDs.

The phosphor according to the first aspect has ordinarily excellent temperature characteristics, as pointed out in section "2-6. Temperature characteristics of the emission peak intensity of the halophosphate phosphor" and "2-7. Temperature characteristics of the emission luminance of the halophosphate phosphor" above. Therefore, the phosphor according to the first aspect is preferable, since problems such as color shift and/or drops in emission intensity are less likely to occur, even as a result of heat generation during energization, also when using a first luminous body in the form of a high-output LED capable of high-output operation and in which the temperature rises up to about 130°C during operation, or in the form of a light-emitting device that relies on, for instance, a large chip.

In a case where, for instance, a large chip has a square peripheral shape, the length of one side thereof is ordinarily 500 $\mu$m or greater, preferably 700 $\mu$m or greater, more preferably 900 $\mu$m or greater, and ordinarily 5 mm or smaller, preferably 3 mm or smaller, and more preferably 2 mm or smaller.

5-2. Second luminous body

The second luminous body in the light-emitting device that uses the halophosphate phosphor according to the first aspect emits visible light as a result of being irradiated with light from the above-described first luminous body, and contains the first phosphor and an appropriate second phosphor according to, for instance, the intended application. For instance the second luminous body may have a configuration wherein the first and/or the second phosphor are dispersed in the below-described encapsulating material.

5-2-1. First phosphor

An explanation follows next on a light-emitting device that uses the halophosphate phosphor according to the first aspect. The second luminous body contains the phosphor according to the first aspect. The second luminous body contains, as the first phosphor, at least one type of the phosphor according to the first aspect. As the first phosphor there can be simultaneously used, besides the phosphor according to the first aspect, a phosphor that emits fluorescence of the same color as that of the phosphor according to the first aspect (such a phosphor may also be referred to hereafter as "same-color concomitant phosphor"). Ordinarily, the phosphor according to the first aspect is a blue to blue-green phosphor. As the first phosphor, therefore, another type of blue to blue-green (same-color concomitant phosphor) can be concomitantly used together with the phosphor according to the first aspect. Examples of a same-color concomitant phosphor include, for instance, $BaMgAl_{10}O_{17}$:Eu, $Sr_5(PO_4)_3Cl$:Eu or the like.

5-2-2. Second phosphor

Depending on the intended application, the second luminous body in the light-emitting device that uses the halophosphate phosphor according to the first aspect may contain a phosphor (i.e. a second phosphor) other than the above-described first phosphor. The second phosphor has a different emission wavelength from that of the first phosphor. Ordinarily, the second phosphor is used in order to regulate the color tone of the light emitted by the second luminous body. Therefore, a phosphor that emits fluorescence of a color different from that of the first phosphor is often used as the second phosphor.

As described above, the phosphor according to the first aspect is ordinarily used as the first phosphor. Therefore, a phosphor having for instance an emission peak within a wavelength range from 510 nm to 550 nm (hereafter referred also to as "green phosphor"), or a phosphor having an emission peak within a wavelength range from 580 nm to 680 nm (hereafter, referred also to as "red phosphor") is preferably used as the second phosphor. A yellow phosphor can also be used.

As the second phosphor there may be used one type of phosphor alone, or alternatively there may be concomitantly used two or more types of phosphor in arbitrary combinations and ratios. The ratio between the first phosphor and the second phosphor may be any ratio, so long as the effect of the present invention is not significantly impaired thereby. Therefore, the amount of second phosphor that is used, as well as the combination and ratios of the phosphors that are used as the second phosphor, may be arbitrarily set in accordance with, for instance, the application of the light-emitting device.

A more detailed explanation of the second phosphor follows next.

5-2-2-1. Green phosphor

If a green phosphor is used as the second phosphor, the emission peak wavelength of the green phosphor is ordinarily greater than 500 nm, preferably 510 nm or greater, and more preferably 515 nm or greater, and ordinarily 550 nm or smaller, preferably 540 nm or smaller and more preferably 535 nm or smaller. If the emission peak wavelength is too short, emission tends to turn bluish, while too long an emission peak wavelength tends to result in yellowish emission. In either case the characteristics of the green light may become impaired as a result.

The half width of the emission peak of the green phosphor ranges ordinarily from 40 nm to 80 nm. The external quantum efficiency is ordinarily 60% or greater, preferably 70% or greater. The weight median diameter of the green phosphor is ordinarily 1 $\mu$m or greater, preferably 5 $\mu$m or greater and more preferably 10 $\mu$m or greater, and ordinarily 30 $\mu$m or smaller, preferably 20 $\mu$m or smaller, and more preferably 15 $\mu$m or smaller.

Examples of such a green phosphor include, for instance, the Eu-activated alkaline earth silicate phosphor represented by (Ba, Ca, Sr, Mg) $_2SiO_4$: Eu (hereafter also referred to as "BSS phosphor" for short) disclosed in WO 2007-091687.

Other green phosphors that can be used are, for instance, an Eu-activated oxynitride phosphor such as $Si_{6-2}Al_zN_{8-z}O_z$: Eu (wherein $0 < z \leq 4.2$, hereafter also "$\beta$-SiAlON phosphor" for short) disclosed in Japanese Patent No. 3921545; an Eu-activated oxynitride phosphor such as $M_3Si_6O_{12}N_2$:Eu (wherein M denotes an alkaline earth metal element, hereafter also "BSON phosphor" for short) disclosed in WO 2007-088966; or a $BaMgAl_{10}O_{17}$:Eu,Mn-activated aluminate phosphor (hereafter also referred to as "GBAM phosphor" for short) disclosed in JP-A-2008-274254.

Other examples of green phosphors include, for instance, Eu-activated alkaline earth silicon oxynitride phosphors such as $(Mg,Ca,Sr,Ba)Si_2O_2N_2$:Eu; Eu-activated aluminate phosphors such as $Sr_4Al_{14}O_{25}$: Eu or (Ba, Sr, Ca) $Al_2O_4$ : Eu; Eu-activated silicate phosphors such as $(Sr,Ba)Al_2Si_2O_8$:Eu, $(Ba,Mg)_2SiO_4$:Eu, $(Ba,Sr,Ca)_2(Mg,Zn)Si_2O_7$:Eu, $(Ba,Ca,Sr,Mg)_9(Sc,Y,Lu,Gd)_2(Si,Ge)_6O_{24}$:Eu or the like; Ce,Tb-activated silicate phosphors such as $Y_2SiO_5$:Ce,Tb; Eu-activated borate phosphate phosphors such as $Sr_2P_2O_7-Sr_2B_2O_5$:Eu; Eu-activated halosilicate phosphors such as $Sr_2Si_3O_8-2SrCl_2$:Eu; Mn-activated silicate phosphors such as $Zn_2SiO_4$:Mn; Tb-activated aluminate phosphors such as $CeMgAl_{11}O_{19}$: Tb and $Y_3Al_5O_{12}$:Tb; Tb-activated silicate phosphors such as $Ca_2Y_8(SiO_4)_6O_2$: Tb and $La_3Ga_5SiO_{14}$:Tb; Eu,Tb,Sm-activated thiogallate phosphors such as (Sr, Ba, Ca) $Ga_2S_4$:Eu, Tb, Sm; Ce-activated aluminate phosphors such as $Y_3(Al,Ga)_5O_{12}$:Ce and $(Y,Ga,Tb,La,Sm,Pr,Lu)_3(Al,Ga)_5O_{12}$:Ce; Ce-activated silicate phosphors such as $Ca_3Sc_2Si_3O_{12}$:Ce and $Ca_3(Sc,Mg,Na,Li)_2Si_3O_{12}$:Ce; Ce-activated oxide phosphors such as $CaSC_2O_4$:Ce; Eu-activated oxynitride phosphors such as Eu-activated $\beta$-Sialon; Eu-activated aluminate phosphors such as $SrAl_2O_4$:Eu; Tb-activated oxysulfide phosphors such as $(La,Gd,Y)_2O_2S$:Tb; Ce,Tb-activated phosphate phosphors such as $LaPO_4$:Ce,Tb; sulfide

phosphors such as ZnS:Cu,Al and ZnS:Cu,Au,Al; Ce,Tb-activated borate phosphors such as (Y, Ga, Lu, Sc, La) $BO_3$: Ce, Tb, $Na_2Gd_2B_2O_7$: Ce, Tb and $(Ba,Sr)_2(Ca,Mg,Zn)B_2O_6$:K,Ce,Tb; Eu,Mn-activated halosilicate phosphors such as $Ca_8Mg(SiO_4)_4Cl_2$:Eu, Mn; Eu-activated thioaluminate phosphors or thiogallate phosphors such as $(Sr,Ca,Ba)(Al,Ga,In)_2S_4$:Eu; Eu,Mn-activated halosilicate phosphors such as $(Ca,Sr)_8(Mg,Zn)(SiO_4)_4Cl_2$:Eu,Mn; and Eu-activated oxynitride phosphors such as $M_3Si_6O_9N_4$:Eu or the like.

The phosphor $Sr_5Al_5Si_{21}O_2N_{35}$: Eu disclosed in WO 2009-072043 and $Sr_3Si_{13}Al_3N_{21}O_2$:Eu disclosed in WO 2007-105631 can also be used herein.

Preferred green phosphors among the foregoing are the BSS phosphor, the β-SiAlON phosphor and the BSON phosphor.

The above-described green phosphors may be used one type alone, or as two or more types in arbitrary combinations and ratios.

5-2-2-2. Red phosphor

In case of using a red phosphor as the second phosphor, the emission peak wavelength of the red phosphor is ordinarily 565 nm or greater, preferably 575 nm or greater, more preferably 580 nm or greater and ordinarily 780 nm or smaller, preferably 700 nm or smaller, more preferably 680 nm or smaller.

The half width of the emission peak of the red phosphor ranges ordinarily from 1 nm to 100 nm. The external quantum efficiency is ordinarily 60% or greater, preferably 70% or greater. The weight median diameter of the red phosphor is ordinarily 1 μm or greater, preferably 5 μm or greater and more preferably 10 μm or greater, and ordinarily 30 μm or smaller, preferably 20 μm or smaller, and more preferably 15 μm or smaller.

As such a red phosphor there can be used, for instance, an Eu-activated oxide, nitride or oxynitride phosphor, such as $CaAlSiN_3$:Eu disclosed in JP-A-2006-008721, $(Sr,Ca)AlSiN_3$:Eu disclosed in JP-A-2008-7751 or $Ca_{1-x}Al_{1-z}Si_{1+x}N_{3-x}O_x$: Eu disclosed in JP-A-2007-231245, and $(Sr,Ba,Ca)_3SiO_5$:Eu (hereafter also referred to as "SBS phosphor" for short) disclosed in JP-A-2008-38081.

Other examples of red phosphors include, for instance, Eu-activated alkaline earth silicon nitride phosphors such as $(Mg, Ca, Sr, Ba)_2Si_5N_8$: Eu; Eu-activated oxysulfide phosphors such as $(La,Y)_2O_2S$:Eu; Eu-activated rare-earth oxychalcogenide phosphors such as $(Y,La,Gd,Lu)_2O_2S$:Eu; Eu-activated oxide phosphors such as $Y(V,P)O_4$:Eu and $Y_2O_3$:Eu; Eu,Mn-activated silicate phosphors such as $(Ba,Mg)_2SiO_4$:Eu,Mn and $(Ba,Sr,Ca,M_9)_2SiO_4$:Eu,Mn; Eu-activated tungstate phosphors such as $LiW_2O_8$:Eu, $LiW_2O_8$:Eu,Sm, $Eu_2W_2O_9$, $Eu_2W_2O_9$:Nb and $Eu_2W_2O_9$:Sm; Eu-activated sulfide phosphors such as $(Ca,Sr)S$:Eu; Eu-activated aluminate phosphors such as $YAlO_3$:Eu; Eu-activated silicate phosphors such as $Ca_2Y_8(SiO_4)_6O_2$:Eu and $LiY_9(SiO_4)_6O_2$:Eu; Ce-activated aluminate phosphors such as $(Y,Gd)_3Al_5O_{12}$:Ce and $(Tb,Gd)_3Al_5O_{12}$:Ce; Eu-activated oxide, nitride or oxynitride phosphors such as $(Mg,Ca,Sr,Ba)_2Si_5(N,O)_8$:Eu, $(Mg,Ca,Sr,Ba)Si(N,O)_2$:Eu and $(Mg,Ca,Sr,Ba)AlSi(N,O)_3$:Eu; Eu,Mn-activated halophosphate phosphors such as $(Sr, Ca, Ba, Mg)_{10}(PO_4)_6Cl_2$:Eu,Mn; Eu, Mn-activated silicate phosphors such as $Ba_3MgSi_2O_8$:Eu,Mn and $(Ba,Sr,Ca,Mg)_3(Zn,Mg)Si_2O_8$:Eu,Mn; Mn-activated germanate phosphors such as $3.5MgO \cdot 0.5MgF_2 \cdot GeO_2$:Mn; Eu-activated oxynitride phosphors such as Eu-activated α-Sialon; Eu,Bi-activated oxide phosphors such as $(Gd,Y,Lu,La)_2O_3$:Eu,Bi; Eu,Bi-activated oxysulfide phosphors such as $(Gd, Y, Lu, La)_2O_2S$:Eu, Bi; Eu, Bi-activated vanadate phosphors such as $(Gd,Y,Lu,La)VO_4$:Eu,Bi; Eu,Ce-activated sulfide phosphors such as $SrY_2S_4$:Eu,Ce; Ce-activated sulfide phosphors such as $CaLa_2S_4$:Ce; Eu, Mn-activated phosphate phosphors such as $(Ba, Sr, Ca) MgP_2O_7$: Eu, Mn and $(Sr,Ca,Ba,Mg,Zn)_2P_2O_7$:Eu,Mn; Eu,Mo-activated tungstate phosphors such as $(Y,Lu)_2WO_6$:Eu,Mo; Eu,Ce-activated nitride phosphors such as $(Ba,Sr,Ca)_xSi_yN_z$:Eu,Ce (wherein x, y and z are integers equal to or greater than 1); Eu,Mn-activated halophosphate phosphors such as $(Ca, Sr, Ba, Mg)_{10} (PO_4)_6 (F, Cl, Br, OH)$ : Eu, Mn; and Ce-activated silicate phosphors such as $((Y, Lu, Gd, Tb)_{1-x-y}Sc_xCe_y)_2 (Ca, Mg)_{1-r}(Mg,Zn)_{2+r}Si_{z-q}Ge_qO_{12+\delta}$.

As the red phosphor there can also be used a red phosphor having a red emission spectrum half width of 20 nm or less, singly or mixed with another red phosphor, in particular a red phosphor having a red emission spectrum half width of 50 nm or greater. Examples of such red phosphors include, for instance, KSF or KSNAF, represented by $A_{2+x}M_yMn_zF_n$ (where A is Na and/or K; M is Si and Al; and $-1 \leq x \leq 1$, $0.9 \leq y+z \leq 1.1$ , $0.001 \leq z \leq 0.4$ and $5 \leq n \leq 7$), or a solid solution of KSF and KSNAF; manganese-activated deep red (600 nm to 670 nm) germanate phosphors, such as $3.5MgO \cdot 0.5MgF_2 \cdot GeO_2$:Mn or the like, represented by chemical formula $(k-x)MgO \cdot xAF_2 \cdot GeO_2$:yMn$^{4+}$ (where k is a real number ranging from 2.8 to 5; x is a real number ranging from 0.1 to 0.7; y is a real number ranging from 0.005 to 0.015; A is calcium (Ca), strontium (Sr), barium (Ba), zinc (Zn) or a mixture thereof); or a LOS phosphor represented by chemical formula $(La_{1-x-y}, Eu_x, Ln_y)_2O_2S$ (wherein x and y represent numbers that satisfy $0.02 \leq x \leq 0.50$ and $0 \leq y \leq 0.50$, respectively; and Ln represents at least one trivalent rare earth element from among Y, Gd, Lu, Sc, Sm and Er).

The phosphor $SrAlSi_4N_7$ disclosed in WO 2008-096300 and $Sr_2Al_2Si_9O_2N_{14}$: Eu disclosed in US Patent No. 7524437 can also be used herein.

Preferred red phosphors among the foregoing are the CASN phosphor, the SCASN phosphor, the CASON phosphor or an SBS phosphor.

The above-described red phosphors may be used as one type alone of any of the phosphors, or as two or more types in arbitrary combinations and ratios.

5-3-1. Combination of the first luminous body, first phosphor and second phosphor

In the light-emitting device using the halophosphate phosphor according to the first aspect, the presence or absence as well as the type of the second phosphor (green phosphor and red phosphor) explained above may be appropriately selected in accordance with the application of the light-emitting device. In a case, for instance, where the first phosphor is a blue phosphor and the light-emitting device of the present invention is used as blue-emission light-emitting device, there may be used the first phosphor alone, so that, ordinarily, the second phosphor need not be used.

A light-emitting device can be configured by specifically combining the first phosphor (blue phosphor) and the second phosphor, as phosphors contained in the second luminous body, so as to achieve light of a desired color. For instance, a blue phosphor (phosphor of the present invention or the like) is used as the first phosphor, and a green phosphor and a red phosphor are used as the second phosphor. As a result, a light-emitting device can be configured that emits white light and that, in particular, enables fine adjustment to day white or warm white.

Preferably, in particular, the BSS phosphor is used as the green phosphor and the CASON phosphor is used as the red phosphor. Preferably, the $\beta$-SiAlON phosphor is used as the green phosphor and the CASON phosphor is used as the red phosphor. Preferably, the $\beta$-SiAlON phosphor is used as the green phosphor and the SBS phosphor is used as the red phosphor. Preferably, the $\beta$-SiAlON phosphor is used as the green phosphor and the SCASN phosphor is used as the red phosphor.

5-3-2. Sedimentation rate and density of the phosphor

In the light-emitting device of the present invention, the blue phosphor, green phosphor and red phosphor are dispersed in a light-transmitting material and are encapsulated thereafter in the white light-emitting device. Preferably, the ratio of the sedimentation rate of the blue phosphor in the light-transmitting material with respect to that of the green phosphor ranges from 0.70 to 1.30, and the ratio of the sedimentation rate of the red phosphor with respect to that of the green phosphor ranges from 0.70 to 1.30. Preferably, the above values of the ratio of sedimentation rate are satisfied for all phosphors, in a case where a plurality thereof is used, and for all colors.

In a case where a blue phosphor, a green phosphor and a red phosphor were used in the light-emitting device, the phosphors were ordinarily dispersed in a below-described light-transmitting material, followed by encapsulation into the white light-emitting device, and curing. However, chromaticity variability occurred in the produced white light-emitting device, and therefore it was necessary to enhance yield, given that not all the white light-emitting devices could be shipped as finished products.

The inventors conducted studies on improving chromaticity variability in such white light-emitting devices, and found that it was possible to curb chromaticity variability if the ratios of sedimentation rate of the phosphors in the light-transmitting material were constant. Thus far, phosphors that are dispersed in a light-transmitting material in light-emitting devices underwent sedimentation before curing of the light-transmitting material, and thus dispersibility in the light-transmitting material was insufficient at the time of curing. The inventors speculated that this occurrence underlies variability in chromaticity, and found that the durability of the white light-emitting device could be enhanced by suppressing this variability.

Specifically, the phosphor dispersed in the light-transmitting material does not sediment, and sufficient dispersibility can be preserved also after curing, if the ratio of the sedimentation rate of the blue phosphor in the light-transmitting material with respect to that of the green phosphor ranges from 0.70 to 1.30, or the ratio of the sedimentation rate of the red phosphor with respect to that of the green phosphor ranges from 0.70 to 1.30. Variability in chromaticity can be suppressed as a result. The ratio of the sedimentation rate is more preferably 0.80 or greater, and yet more preferably 0.85 or greater. The upper limit is more preferably 1.20 or smaller, and yet more preferably 1.15 or smaller. A light-transmitting resin material is ordinarily used as the light-transmitting material. Specific examples include, for instance, epoxy resins and silicone resins that are used as the below-described encapsulating material.

Preferably, the densities of the blue phosphor, green phosphor and red phosphor range all from 3.0 to 5.0 g/cm$^3$. Using a phosphor lying within such a range allows suppressing sedimentation of the phosphor in the light-transmitting resin material, and allows preventing variability in chromaticity.

An example of a phosphor combination that satisfies such a ratio of sedimentation rate include, for instance, the blue phosphor of the present invention, and, in addition, a $\beta$-SiAlON phosphor as a green phosphor and a CASON phosphor as a red phosphor.

The sedimentation rate can be calculated according to the Stokes' equation (Stokes' law) on the basis of the density and particle size of the phosphor.

[Formula 1]

$$v_s = \frac{D_p{}^2(\rho_p - \rho_f)g}{18\eta}$$

In the equation, $v_s$ denotes the sedimentation rate of the phosphor, Dp denotes the particle size of the phosphor, $\rho_p$ denotes the density of the phosphor particles, $\rho_f$ denotes the density of the light-transmitting material, and $\eta$ denotes the viscosity of a fluid (light-transmitting material).

In a case where the light-emitting device has a plurality of types of blue phosphor, green phosphor and red phosphor, the respective sedimentation rate used for working out the ratios of sedimentation rate is a mean value of the sedimentation rates of the plurality of types of phosphor.

5-4. Encapsulating material

In the light-emitting device that uses the halophosphate phosphor according to the first aspect, the first and/or second phosphor is ordinarily used by being dispersed and encapsulated in a light-transmitting material. Suitable examples of light-transmitting materials include, for instance, encapsulating materials that are utilized for protecting LED chips. Examples of encapsulating materials include, for instance, the same materials as those set forth in the section "4. Phosphor-containing composition" above. When using a first luminous body such as an LED or the like whose peak wavelength is at a near-ultraviolet region from 350 nm to 430 nm, the encapsulating material is preferably a resin having durability and sufficient transparency to that emission light.

Examples of the encapsulating material include, for instance, epoxy resins and silicone resins. An inorganic material having siloxane bonds, or glass, may also be used.

Preferred among the foregoing , in terms of heat resistance, ultraviolet (UV) resistance and so forth, are for instance, a silicone resin as a silicon-containing compound, a metal alkoxide, a ceramic precursor polymer, or an inorganic material, for instance an inorganic material having siloxane bonds, resulting from solidifying a solution obtained by hydrolysis polymerization, by a sol-gel method, of a solution that contains a metal alkoxide, or resulting from solidifying a combination of the foregoing.

The above encapsulating materials may be used as one type, or may be used concomitantly as two or more types in arbitrary combinations and ratios. The encapsulating material may contain an organic solvent.

The encapsulating material may contain other arbitrary components, in accordance with, for instance, the intended application. Examples of other components include, for instance, spreading agents, thickeners, fillers, interference agents and the like. Specific examples include, for instance, silica fine powders such as aeorsil, as well as alumina. Such other components may be used a one type alone, or may be used concomitantly as two more types in arbitrary combinations and ratios.

5-5-1. Configuration of the light-emitting device (other features)

Provided that the light-emitting device comprises the above-described first luminous body and second luminous body, the light-emitting device that uses the halophosphate phosphor according to the first aspect is not particularly limited as regards other features. Ordinarily, however, the above-described first luminous body and second luminous body are disposed on a appropriate frame. In this case, the first luminous body and second luminous body are arranged in such a manner that the second luminous body is excited (i.e. the first and the second phosphors are excited) and generates light on account of the light emitted by the first luminous body, and the light emitted by the first luminous body and/or the light emitted by the second luminous body is extracted towards the exterior. In such a case, the first phosphor and the second phosphor need not necessarily be mixed into a same layer, and, for instance, the phosphor may be incorporated in separate layers for each emission color of the respective phosphor; for example the layer containing the second phosphor may be overlaid on the layer containing the first phosphor.

Members other than the above-described excitation light source (first luminous body), phosphor (second luminous body) and frame may also be used in the light-emitting device according to the first aspect. Examples of such members include the above-described encapsulating material. In addition to the purpose of dispersing the phosphor (second luminous body) in the light-emitting device, the encapsulating material can also be used for the purpose of bonding the excitation light source (first luminous body), the phosphor (second luminous body) and the frame to one another.

5-6. Applications of the light-emitting device

The use of the light-emitting device according to the first aspect is not particularly limited, and the light-emitting device can be used in various fields where light-emitting devices are ordinarily utilized. The light-emitting device is particularly suitable as a light source in illumination devices and image display devices, thanks to the wide color reproducible gamut and high color rendering properties that are afforded.

5-7. Illumination device

An illumination device according to the first aspect comprises the light-emitting device of the present invention.
In a case where the light-emitting device according to the first aspect is used in an illumination device, a light-emitting device such as the above-described one may be appropriately assembled into a known illumination device.

5-8. Image display device

An image display device according to the first aspect comprises the light-emitting device of the present invention.
In a case where the light-emitting device according to the first aspect is used as a light source of a image display device, the specific configuration of the image display device is not particularly limited, but, preferably, the image display device is used together with a color filter. In a case where, for instance, the image display device is a color image display device that uses a color liquid crystal display element, an image display device can be formed by combining the above-described light-emitting device, as a backlight, with an optical shutter that relies on a liquid crystal, and a color filter having red, green and blue pixels.

6. White light-emitting device

Another mode of the present invention is a white light-emitting device (hereafter also "white light-emitting device according to the second aspect" for short). The white light-emitting device according to the second aspect is a phosphor conversion-type white light-emitting device that comprises a semiconductor light-emitting element that emits light in the near-ultraviolet wavelength region, and a phosphor, such that white light is emitted through wavelength conversion, by the phosphor, of light emitted by the semiconductor light-emitting element, wherein the phosphor includes a blue phosphor having a chemical composition of formula [1] below, a green phosphor having an emission peak wavelength of 535 nm or greater, and at least one type of red phosphor selected from among an Eu-activated nitride phosphor and an Eu-activated oxynitride phosphor, and the color temperature of white light emitted by the white light-emitting device ranges from 1800 K to 7000 K. Preferably, the light color of the white light emitted by the white light-emitting device has a deviation duv of -0.0200 to 0.0200 from a black body radiation locus.

$$(Sr, Ca)_a Ba_b Eu_x (PO_4)_c X_d \qquad [1]$$

(In general formula [1], X is Cl; c, d and x are numbers satisfying $2.7 \leq c \leq 3.3$, $0.9 \leq d \leq 1.1$ and $0.3 \leq x \leq 1.2$; and a and b satisfy the conditions $a+b = 5-x$ and $0.12 \leq b/(a+b) \leq 0.4$.).
The white light-emitting device according to the second aspect is not limited by the way in which the semiconductor light-emitting element and the phosphor are optically coupled, and a transparent medium (such as air) may simply fill a gap between the semiconductor light-emitting element and the phosphor; alternatively, an optical element such as a lens, an optical fiber or a light guide plate may be interposed between the semiconductor light-emitting element and the phosphor.
The phosphor comprised in the white light-emitting device according to the second aspect is not limited by the form of the phosphor. The phosphor may be in the form of microparticles, or in the form of a luminescent ceramic that contains a phosphor phase. A phosphor in microparticulate form is incorporated into a light-emitting device by being dispersed in a transparent matrix comprising a polymer material or glass, or, alternatively, is incorporated in a fixed state, in accordance with ordinary methods, such as deposition by electrodeposition or the like, on the surface of an appropriate member.
The white light-emitting device according to the second aspect can be a so-called white LED. The commonest white LEDs have a structure in which a LED chip is mounted in a package of round type, SMD type or the like, and in which a phosphor is added in the form of microparticles in an encapsulating resin that covers the surface of the LED chip.
The features of the various elements of the white light-emitting device according to the second aspect are explained in detail below.

6-1. Semiconductor light-emitting element

The semiconductor light-emitting element used in the white light-emitting device according to the second aspect is a light-emitting diode (LED) or laser diode (LD) capable of emitting light in a near-ultraviolet wavelength region, i.e. in a wavelength range from 350 to 430 nm, and is preferably a GaN-based LED or LD having a light-emitting structure that relies on a GaN-based semiconductor such as GaN, AlGaN, GaInN or AlGaInN. An LED or LD having a light-emitting structure relying on a ZnO-based semiconductor is also preferred, other than GaN-based semiconductors. Particularly preferred, among GaN-based LEDs having an emissive section made up of a GaN-based semiconductor that comprises In, is a GaN-based LED whose emissive section is a quantum well structure comprising an InGaN layer, since in that case emission intensity is very strong. The emission peak wavelength of the GaN-based LED is preferably 400 nm or greater, more preferably 405 nm or greater, yet more preferably 407 nm or greater, and preferably 425 nm or smaller, more preferably 420 nm or smaller, and yet more preferably 415 nm or smaller. The emission efficiency of a GaN-based LED tends to drop if the emission peak wavelength is smaller than 400 nm. The excitation efficiency of the below-described blue phosphor tends to drop if the emission peak wavelength exceeds 425 nm.

6-2. Blue phosphor

The white light-emitting device according to the second aspect uses, as a blue phosphor, a halophosphate phosphor having the chemical composition of general formula [1] below (hereafter also referred to as "blue phosphor (I)" for short).

$$(Sr,Ca)_a Ba_b Eu_x (PO_4)_c X_d \qquad [1]$$

(In general formula [1], X is Cl; c, d and x are numbers satisfying $2.7 \leq c \leq 3.3$, $0.9 \leq d \leq 1.1$ and $0.3 \leq x \leq 1.2$; and a and b satisfy the conditions $a+b = 5-x$ and $0.12 \leq b/(a+b) \leq 0.4$.)

Herein, a, b, x, c and d denote, respectively, the mole ratio of Sr, the mole ratio of Ba, the mole ratio of Eu, the mole ratio of the $PO_4$ group, and the mole ratio of the anion group X. For instance, a composition $Eu_{0.5}Sr_{3.825}Ba_{0.675}(PO_4)_3Cl$ implies $a = 3.825$, $b = 0.675$, $x = 0.5$, $c = 3$, $d = 1$, and hence falls within the above formula [1].

The phosphor may contain elements other than the above-mentioned ones, so long as the effect of the present invention is not significantly impaired thereby.

The general formula [1] of the blue phosphor (I) used in the white light-emitting device according to the second aspect is the same as that of the halophosphate phosphor according to the first aspect. However, if the halophosphate phosphor according to the first aspect is used in the white light-emitting device according to the second aspect, then a preferred range of the blue phosphor (I) may differ from a preferred range of the halophosphate phosphor according to the first aspect when the phosphor is used singly. The explanation below will focus on this difference.

In the blue phosphor (I), as indicated by formula [1], the phosphor contains specific amounts of Sr, Ca and Ba. Specifically, a mole ratio a of Sr and Ca and a mole ratio b of Ba satisfy the conditions $a+b = 5-x$ and $b/(a+b)$ value ranging from 0.12 to 0.4. The emission peak in the emission spectrum broadens as the $b/(a+b)$ value increases. In particular, the half width increases abruptly when the $b/(a+b)$ value is 0.16 or greater. This broadening of the emission peak takes place mainly at longer wavelengths than the emission peak wavelength, and hence is accompanied by a significant increase in luminance. This emission peak broadening tends to saturate when the $b/(a+b)$ value is 0.4 or smaller, in particular 0.34 or smaller.

The reason for setting the lower limit of the $b/(a+b)$ value to 0.12 is that if the value is too small, the emission intensity of the blue phosphor (I) at the wavelength region around 490 nm fails to become sufficiently high, and, as a result, the object of the present invention becomes difficult to achieve. The $b/(a+b)$ value has no particular upper limit, but as described above, broadening of the emission peak tends to saturate if the value is 0.4 or smaller, in particular 0.34 or smaller. Therefore, the object of the present invention can be preferably achieved by appropriately setting the value ordinarily to 0.6 or smaller, preferably, 0.4 or smaller.

As regards the emission characteristics of the blue phosphor (I), the spectrum (emission spectrum) of the fluorescence emitted by the blue phosphor (I) upon excitation with light of wavelength 410 nm has an emission peak wavelength that is ordinarily 440 nm or greater, preferably 450 nm or greater, and ordinarily 475 nm or smaller, preferably 460 nm or smaller. Particularly high color rendering properties in the white light-emitting device can be achieved when the emission peak wavelength lies within the range from 450 to 460 nm.

As described above, the half width of the emission peak of the blue phosphor (I) in the emission spectrum resulting from excitation light with light of wavelength 410 nm varies depending on the $b/(a+b)$ value in formula [1]. In other words, the above half width can be controlled by using $b/(a+b)$ as a parameter. The I(490 nm)/I(peak) value in the emission spectrum of the blue phosphor (I) upon excitation with light of wavelength 410 nm, wherein I (peak) denotes the intensity of the emission peak wavelength and I(490 nm) denotes the emission intensity at a wavelength 490 nm, behaves in a way similar to the above-described half width in response to changes in the b/(a+b) value. Herein, the intensity of the emission peak wavelength denotes the emission intensity at the wavelength of the peak top of the emission peak.

In the white light-emitting device according to the second aspect, as described below, it becomes possible to prevent drops in bright blue reproducibility by compensating, through emission from the blue phosphor (I), the component in the wavelength region around 490 nm for which the emission spectrum of the green phosphor is insufficient. Therefore, the I(490 nm)/I(peak) value of the blue phosphor (I) is appropriately adjusted using the b/(a+b) value in formula [1] as a parameter, in accordance with the emission characteristics of the green phosphor that is used. If necessary, the I(490 nm)/I(peak) value can be set to 0.5 or greater (when substantially no Ca is present) by setting the b/(a+b) value in formula [1] to 0.16 or greater.

In a specific example of an instance where there is used, as a green phosphor, an Eu-activated oxynitride phosphor or Eu-activated alkaline earth silicate phosphor having an emission peak wavelength ranging from 535 to 545 nm and a half width of the emission peak ranging from 55 to 70 nm, the b/ (a+b) value in formula [1] may be adjusted to lie within a range from 0.15 to 0.20 in such a manner that the emission peak wavelength of the blue phosphor (I) lies within the range from 450 to 460 nm, and the I(490 nm)/I(peak) value ranges from about 0.55 to 0. 65 (instance wherein substantially no Ca is present).

6-3. Green phosphor

The white light-emitting device according to the second aspect uses a green phosphor having an emission peak wavelength at a wavelength of 535 nm or greater when excited with near-ultraviolet light emitted by a semiconductor light-emitting element. As described above, setting the emission peak wavelength to be 535 nm or greater in an Eu-activated oxynitride green phosphor such as the β-SiAlON phosphor or BSON phosphor is an effective means for increasing luminance. However, the emission color turns yellow when the emission peak wavelength is longer than 560 nm. This is not suitable for a white light-emitting device having high color rendering. To prevent loss of color rendering properties in the white light-emitting device, the emission peak wavelength of the green phosphor is preferably set to 550 nm or smaller, more preferably 545 nm or smaller.

Ordinarily, the half width of the emission peak of Eu-activated oxynitride high-luminance green phosphors is 80 nm or smaller. Preferably, however, the half width is 75 nm or smaller, more preferably 70 nm or smaller, and preferably 66 nm or smaller. That is because a wider half width of the emission peak translates into a greater yellow component in the emission spectrum of the green phosphor, which in turn impairs the color rendering properties of the white light-emitting device. In simple terms, the cause of the above phenomenon is that the emission spectrum of the white light-emitting device that uses a green phosphor inevitably approaches the spectrum of white light that comprises only blue light and yellow light as the emission spectrum of the green phosphor approaches that of a yellow phosphor. Such white light, called pseudo-white light, is white in color, but, as is well known, has poor color reproducibility. Ordinarily, the half width of the emission peak of Eu-activated oxynitride high-luminance green phosphors is 50 nm or greater. Preferably, however, the half width is 53 nm or greater, more preferably 55 nm or greater, particularly preferably 60 nm or greater, and most preferably 65 nm or greater.

Eu-activated oxynitride green phosphors such as the β-SiAlON phosphor and BSON phosphor have high peak shape symmetry in the emission spectrum. Therefore, the drop in emission intensity in the wavelength region around 490 nm is significant in a case where the emission peak wavelength is set to 535 nm or greater and, at the same time, the half width of the emission peak is set to 80 nm or smaller. According to the findings of the inventors, decreases in the bright blue reproducibility in white light-emitting devices can be prevented by using in this case the above-described blue phosphor (I). That is because the spectrum at a wavelength around 490 nm can be conceivably compensated by emission from the blue phosphor (I).

As explained above, the invention is not limited to using an Eu-activated oxynitride phosphor as the green phosphor. It should be apparent to a person skilled in the art that a white light-emitting device having good bright blue reproducibility can be obtained by using the blue phosphor (I) also when an Eu-activated alkaline earth silicate phosphor is utilized. Similarly to the β-SiAlON phosphor and BSON phosphor, Eu-activated alkaline earth silicate phosphors exhibit characteristically high peak shape symmetry in the emission spectrum.

6-4. Red phosphor

An Eu-activated nitride phosphor or Eu-activated oxynitride phosphor is used as the red phosphor in the white light-emitting device according to the second aspect. Typical examples of Eu-activated nitride red phosphors include the above-described CASN phosphor and SCASN phosphor. The above-described CASON phosphor is a typical example of Eu-activated oxynitride red phosphor. Ordinarily, these red phosphors have a broad emission band having a peak wavelength in the range from 620 nm to 660 nm, and it is fair to say that these red phosphors are indispensible phosphors in the manufacture of white light-emitting devices having high color rendering. Findings by the inventors have revealed that when these kinds of red phosphor are combined with the above-described green phosphor, a white light-emitting device boasting a high special color rendering index R9 can be achieved by selecting the various phosphors in such a manner that the spectral intensity of output light (white light) does not become excessively high around the wavelength 580 nm. Herein, R9 is a guideline of color rendering properties for bright red.

As the red phosphor there can also be used a red phosphor having a red emission spectrum half width of 20 nm or less, singly or mixed with another red phosphor, in particular a red phosphor having a red emission spectrum half width of 50 nm or greater. Examples of such red phosphors include, for instance, the abovementioned KSF, KSNAF, solid solutions of KSF and KSNAF, manganese-activated deep red germanate phosphors, LOS phosphors and the like.

6-5. Configuration of the light-emitting device

The white light-emitting device according to the second aspect is not particularly limited as regards other features, provided that the white light-emitting device comprises the above-described semiconductor light-emitting element and phosphors. Ordinarily, however, the above-described semiconductor light-emitting element is fixed onto an appropriate frame (leadframe or circuit board), and the above-described phosphor in the form of microparticles is dispersed in a encapsulating material that is used for protecting the light-emitting element thus fixed.

The encapsulating material may be a material that has sufficient transparency and durability towards radiation from the semiconductor light-emitting element and the phosphors, and that disperses appropriately the various phosphors. The encapsulating material may be a light-transmitting material that does not undergo undesirable reactions or the like. Specifically, the encapsulating material can be selected from among, for instance, resins such as silicone resins, epoxy resins, polyvinyl resins, polyethylene resins, polypropylene resins, polyester resins, polycarbonate resins and acrylic resins, and inorganic glass. In terms of heat resistance and light resistance, the encapsulating material is most preferably a silicon-containing compound. The silicon-containing compound is a compound that has silicon atoms in the molecule, and may be for instance an organic material (silicone-based material) such as a polyorganosiloxane, an inorganic material such as silicon oxide, silicon nitride or silicon oxynitride, or a glass material such as a borosilicate, phosphosilicate or alkali silicate. Preferred among the foregoing is a silicone-based material on account of the excellent transparency, adhesiveness, handleability and mechanical/thermal stress relieving characteristics of such materials. A silicone-based material denotes ordinarily an organic polymer having a main chain of siloxane bonds. Herein there can be used, for instance, a silicone-based material of condensation type, addition type, sol-gel type or a photocurable type. Into the encapsulating material there may be mixed not only the phosphor, but also various other additives, as the case may require, for instance spreading agents, thickeners, fillers, interference agents and the like.

In one embodiment, the semiconductor light-emitting element may be covered by multiple layers of the encapsulating material. In this case, there may be provided phosphor-containing layers and phosphor-free layers, or various types of layers, for instance layers containing only a specific phosphor, or layers lacking only a specific phosphor.

The output light of the white light-emitting device according to the second aspect may include part of the light emitted by the semiconductor light-emitting element. This light may be ultraviolet light having no luminosity factor, or may be visible light that makes up part of the white light. In a case where, for instance a semiconductor light-emitting element is used whose emission peak has a peak wavelength of 425 nm and half width of 30 nm, the light emitted by the semiconductor light-emitting element comprises blue light having a wavelength of 440 nm or greater, but this blue light may be included in the output light of the white light-emitting device.

In the white light-emitting device according to the second aspect, the phosphors that convert the wavelength of the light emitted by the semiconductor light-emitting element may include two or more types of phosphors that fall under the blue phosphor (I). So long as the effect of the invention is not impaired thereby, other arbitrary blue phosphors may be incorporated besides the blue phosphor (I).

In the white light-emitting device according to the second aspect, the phosphors that convert the wavelength of the light emitted by the semiconductor light-emitting element may comprise two or more types of green phosphor having an emission peak wavelength of 535 nm or greater. In addition to such green phosphors, other arbitrary green phosphors may also be present so long as the effect of the invention is not impaired thereby.

In the white light-emitting device according to the second aspect, the phosphors that convert the wavelength of the light emitted by the semiconductor light-emitting element may include two or more types of red phosphor that fall under an Eu-activated nitride phosphor or Eu-activated oxynitride phosphor. In addition to such red phosphors, other arbitrary red phosphors may also be present so long as the effect of the invention is not impaired thereby.

In the white light-emitting device according to the second aspect, the phosphors that convert the wavelength of the light emitted by the semiconductor light-emitting element may include, for instance, any phosphor having an emission color other than blue, green or red, for instance a yellow phosphor other than a blue phosphor, green phosphor or red phosphor, provided that the effect of the invention is not impaired thereby.

6-5-1. Remote phosphor

A preferred configuration of the white light-emitting device according to the second aspect is that of a so-called remote phosphor wherein the phosphor forms a phosphor layer, and a distance is left between the phosphor layer and the semiconductor light-emitting element.

In a preferred configuration, a condensing lens is provided on a light exit surface side of the phosphor layer. In another preferred configuration, a light extraction layer is provided on the light exit surface side of the phosphor layer. These configurations are explained next with reference to accompanying drawings.

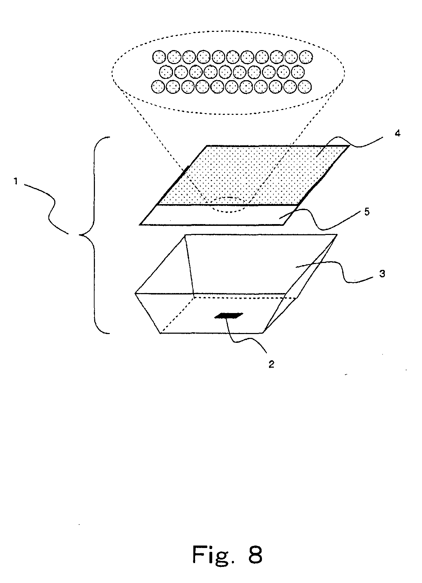

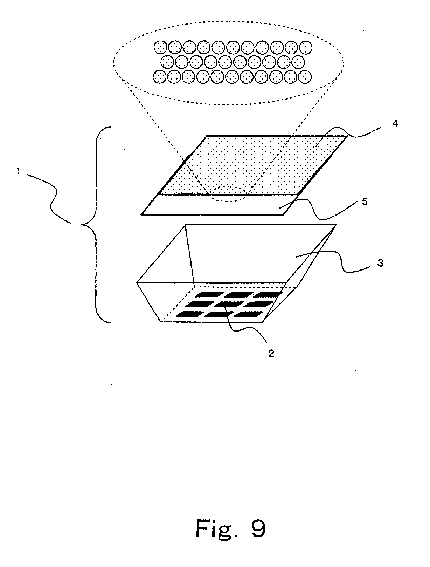

Fig. 8 and Fig. 9 are schematic diagrams of an embodiment of a remote phosphor in the light-emitting device of the present invention.

A light-emitting device 1 is a light-emitting device in which a semiconductor light-emitting element 2 is disposed on a plane. The semiconductor light-emitting element 2 is disposed at the bottom face of a recess of the package 3. A phosphor layer 4 is disposed at an opening portion of the package 3.

The semiconductor light-emitting element 2 is a near-ultraviolet semiconductor light-emitting element that emits light having a wavelength in the near-ultraviolet region. There may be disposed one semiconductor light-emitting element (Fig. 8), as in the present embodiment; alternatively, a plurality of semiconductor light-emitting elements may be disposed in planar fashion (Fig. 9). A light-emitting device may be configured by arranging one semiconductor light-emitting element of large output. Preferably, there is disposed a plurality of semiconductor light-emitting elements, or one semiconductor light-emitting element of large output, since surface illumination can be achieved easily in that case.

A package 3 holds the semiconductor light-emitting element and the phosphor layer. In the present embodiment, the package 3 has a cup-like shape having an opening portion and a recess, such that the semiconductor light-emitting element 2 is disposed at the bottom face of the recess. Directionality can be imparted to the light emitted by the light-emitting device, and the outputted light can be advantageously used, if the package 3 is shaped as a cup. The dimensions of the recess of the package 3 are set in such a manner that the light-emitting device 1 can emit light in a predetermined direction. An electrode (not shown) for supplying power to the semiconductor light-emitting element, from outside the light-emitting device 1, is provided at the bottom of the recess of the package 3. Preferably, a high-reflectance package is used as the package 3. Light that strikes the wall face (tapered portion) of the package 3 can thus be outputted in a predetermined direction and loss of light can be prevented.

The phosphor layer 4 is disposed at the opening portion of the package 3. The opening portion of the recess of the package 3 is covered by the phosphor layer 4. Light from the semiconductor light-emitting element 2 does not pass through the phosphor layer 4, and is not emitted from the light-emitting device 1.

The phosphor layer 4 is formed on a light-transmitting substrate 5 that transmits near-ultraviolet light and visible light, but the phosphor layer 4 is not limited to that arrangement, and may be formed on the light-emitting element side of the light-transmitting substrate 5, or may be kneaded into the light-transmitting substrate 5. Using the light-transmitting substrate 5 allows employing screen printing, so that the phosphor layer 4 can be formed easily. The phosphor layer 4 formed on the light-transmitting substrate has a thickness of 1 mm or less.

In both forms of the present invention as illustrated in Fig. 8 and Fig. 9, a distance is left between the semiconductor light-emitting element 2 and the phosphor layer 4. The distance is preferably 0.1 mm or greater, more preferably 0.3 mm or greater, yet more preferably 0.5 mm or greater, and particularly preferably 1 mm or greater; and is preferably 500 mm or smaller, more preferably 300 mm or smaller, yet more preferably 100 mm or smaller, and particularly preferably 10 mm or smaller. By virtue of such a form, the excitation light per unit surface area of the phosphor is made weaker, so that photodegradation of the phosphor can be prevented, and the temperature of the phosphor layer can be prevented from rising, even if there rises the temperature of the semiconductor light-emitting element. By virtue of such a form, heat generated by the phosphor layer can be prevented from being transmitted up to the vicinity of a bonding wire, in case that bonding wires are used for connection between the semiconductor light-emitting element and the electrode. Also, the tensile force resulting from formation of cracks in the phosphor layer can be prevented from being transmitted up to the bonding wires. As a result, this allows preventing breakage of the bonding wire.

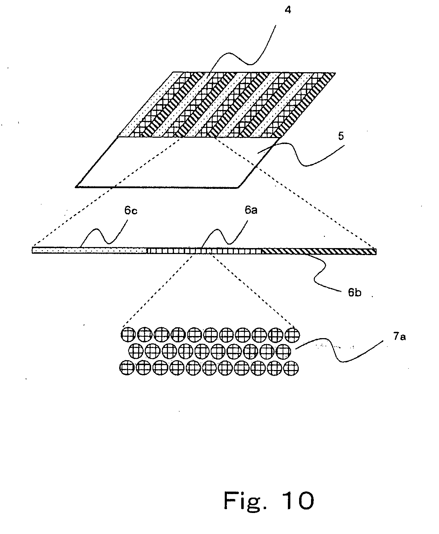

The explanation thus far has dealt with the embodiment of Fig. 8 and Fig. 9, but other embodiments are also possible. Specifically, Fig. 10 illustrates an embodiment wherein the phosphor layer 4 is provided with a first light-emitting member 6a to a third light-emitting member 6c.

In the present embodiment, the first light-emitting member 6a is a light-emitting member that comprises a green phosphor 7a, such that the first light-emitting member 6a is excited by the violet semiconductor light-emitting element 2, and emits thereupon light of a green region being a wavelength component that is longer than that of light of the violet region.

In the present embodiment, the second light-emitting member 6b is a light-emitting member comprising the red phosphor, such that the second light-emitting member 6b is excited by the violet semiconductor light-emitting element 2, and emits thereupon light of a red region being a wavelength component that is longer than that of light of the green region emitted by the green phosphor that is comprised in the first light-emitting member.

In the present embodiment, the third light-emitting member 6c is a light-emitting member that comprises a blue phosphor, and is provided for the purpose of generating white light.

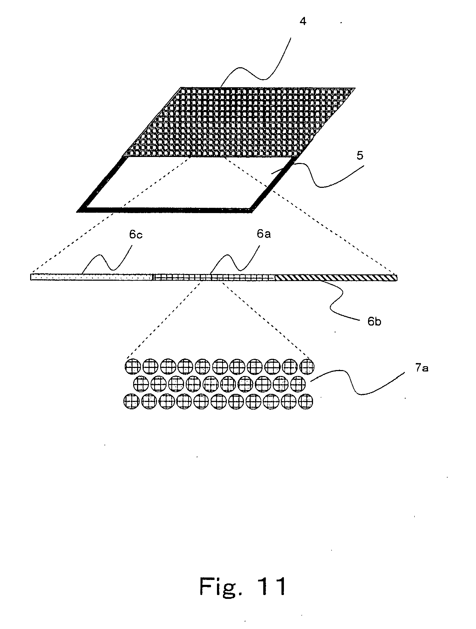

In Fig. 10, each phosphor is disposed on the light-transmitting substrate, in such a manner that the phosphor layer 4 forms stripes, but each phosphor may be disposed otherwise, as illustrated in Fig. 11, in such a manner that the phosphor layer 4 forms a grid.

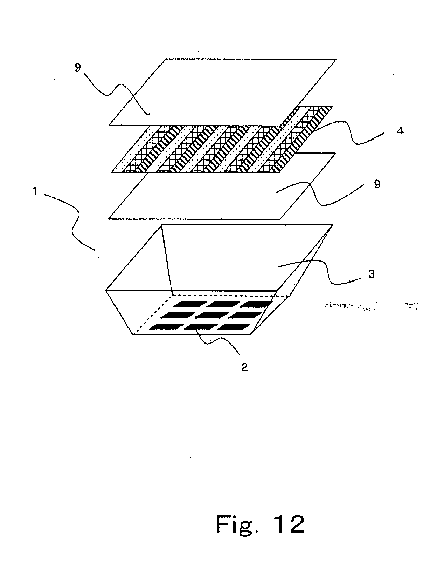

As shown in Fig. 12, a band pass filter 9 can be provided on the phosphor layer 4, on the light exit side face of the light-emitting device and/or on the semiconductor light-emitting element side. Herein, the feature "on the phosphor layer 4, on the light exit side face of the light-emitting device" denotes a face on the side at which light is emitted out of the light-emitting device, from among the faces of the phosphor layer 4 in a direction perpendicular to the thickness direction, i.e. above the phosphor layer 4, in the explanation based on Fig. 12. Also, "on the phosphor layer 4, on the semiconductor light-emitting element side" denotes a face on the side at which light is emitted into the light-emitting device, from among the faces of the phosphor layer 4, in a direction perpendicular to the thickness direction , i.e. below the phosphor layer 4, in the explanation based on Fig. 12.

The band pass filter 9 has the property of letting through only light having a predetermined wavelength. The band pass filter is provided between the package 3 and the phosphor layer 4, such that the band pass filter lets through at least part of light emitted by the semiconductor light-emitting element and reflects at least part of the light emitted by the phosphor. As a result, fluorescent light emitted by the phosphor can be prevented from entering again into the package, and the emission efficiency of the light-emitting device can be increased. The band pass filter is appropriately selected in accordance with the semiconductor light-emitting element 2. Also, arranging a plurality of semiconductor light-emitting elements in a planar fashion, as illustrated in Fig. 9, allows increasing the proportion of light that is incident in the thickness direction of the band pass filter, from among light emitted by the semiconductor light-emitting element, so that the band pass filter can be utilized with yet greater efficiency.

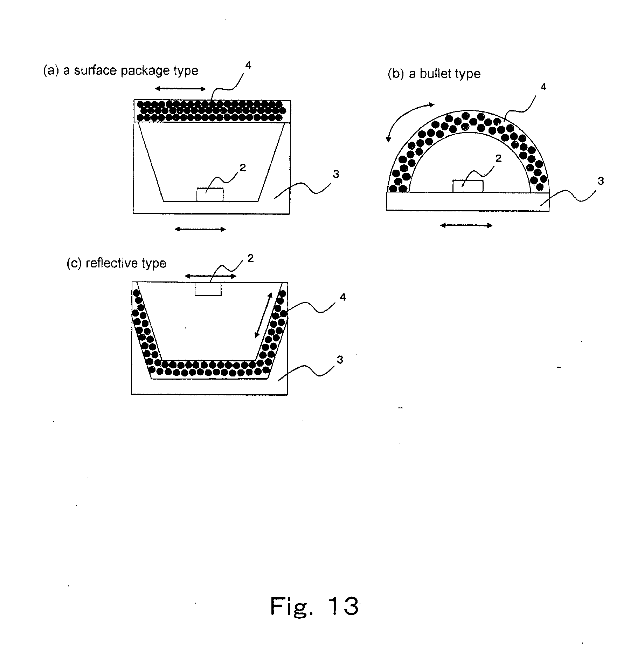

Examples of embodiments of such a remote phosphor include, for instance, (a) a surface package type, (b) a bullet type and (c) and reflective type in Fig. 13. In these types, the phosphor layer 4 or the package 3 can be arranged movably in the direction of the arrows in the figure.

A method for producing the phosphor layer 4 of the remote phosphor may involve kneading a phosphor powder, a binder resin and an organic solvent to yield a paste, coating the paste onto a light-transmitting substrate, and removing the organic solvent by drying and baking. Alternatively, a paste may be formed out of the phosphor and the organic solvent, without using any binder, followed by press molding of a dried sintered material. If a binder is used, any binder may be employed without limitation as regards the type thereof. Preferably, there is used an epoxy resin, a silicone resin, an acrylic resin, a polycarbonate resin or the like.

A glass-encapsulated body may also be formed by dispersing the phosphor into a glass matrix.

In another form, a mixture of the phosphor and binder may be encapsulated by being sandwiched between glass plates.

The material of the light-transmitting of the substrate 5 that lets visible light through is not particularly limited, so long as the material is transparent towards visible light. Examples of the material that can be used include, for instance, glass and plastics (for instance, epoxy resins, silicone resins, acrylic resins, polycarbonate resins and the like). In case of excitation by a wavelength in the near-ultraviolet region, glass is preferably used from the viewpoint of durability.

The package 3 for holding the semiconductor light-emitting element may have any shape and may be of any material. Specific shapes that can be used include, for instance, plate-like shapes or cup-like shapes, and other shapes that are appropriate for the intended application. Among the foregoing, cup-shaped packages are preferred in that they allow imparting directionality to the exit direction of light, and allow utilizing the light emitted by the light-emitting device in an effective manner. In the case of a cup-like package, the surface area of the opening portion through which light exits ranges preferably from 120% to 600% of the bottom surface area. As the material of the package there can be used materials that are appropriate for the intended application, for instance inorganic materials such as metals, alloy glass, carbon or the like, or organic materials such as synthetic resins or the like.

Preferably, a material is used that has high reflectance to light in the near-ultraviolet region and the entire visible region. Examples of such high-reflection packages include, for instance, packages formed of silicone resin that comprise light-scattering particles. Examples of light-scattering particles include, for instance, titania and alumina.

6-5-2. Light extraction layer

In a preferred form, the configuration of the remote phosphor is supplemented with a light extraction layer that is provided on the light exit surface side of the phosphor layer. In a case where the phosphor layer is kneaded into the light-transmitting substrate, the light extraction layer is provided at the light exit surface side of the light-transmitting substrate that is the phosphor layer. In a case where the phosphor layer is provided on the semiconductor light-emitting element side of the light-transmitting substrate, the light-transmitting substrate may be the light extraction layer, or the light extraction may be provided on the light exit surface side of the light-transmitting substrate.

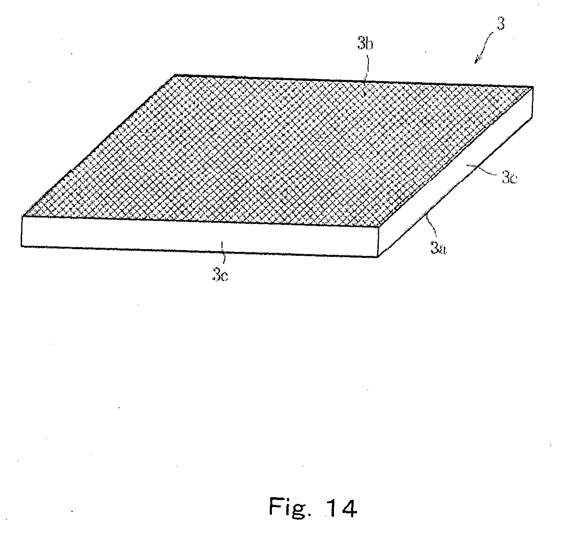

A light-transmitting substrate 13 illustrated in Fig. 14 has a plate-like shape that has a first face 13a and a second face 13b. The light-transmitting substrate 13 has a light transmission characteristic such that primary light emitted from the phosphor layer passes through the light-transmitting substrate 13 and exits out of the second face 13b.

At least part of the primary light emitted from the phosphor layer is scattered by the light extraction layer. As a result, primary light is synthesized satisfactorily, and exit light of steady good quality can be obtained.

As such a light extraction layer, an additive that promotes scattering of primary light may be added, as the case may require, to the light-transmitting substrate 13, or the second face 13b of the light-transmitting substrate 13 may be subjected to a surface treatment for promoting scattering of primary light in the light-transmitting substrate 13. Fig. 14 to Fig. 17 illustrate examples of a surface treatment performed on the second surface 13b of the light-transmitting substrate 13. Fig. 14 to Fig. 17 are perspective-view diagrams illustrating the light-transmitting substrate 3 wherein the third face 13b has been subjected to an abovementioned surface treatment. The surface treatments are depicted schematically, and the scale and so forth are not illustrated in an exact manner.

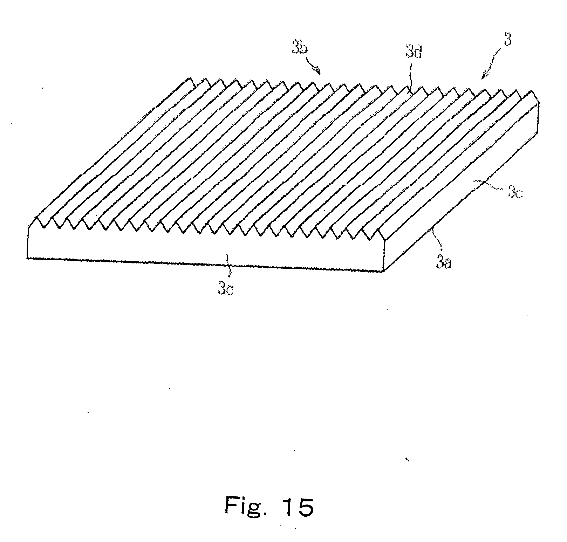

As an example of such a surface treatment for promoting extraction of light out of the light-transmitting substrate, Fig. 14 is a perspective-view diagram illustrating an example of the light-transmitting substrate 13 wherein the second face 13b has been roughened to form fine irregularities thereon. Fig. 15 is a perspective-view diagram illustrating an example of the light-transmitting substrate 13 wherein, instead of such surface roughening, the second face 13b is imparted with a V-groove/triangular prism shape. In the example of Fig. 15, a plurality of mutually parallel V-grooves are formed on the second face 13b; as a result, a V-groove/triangular prism shape is formed wherein V-grooves and prism-shaped ridges 13d having a triangular cross-sectional shape are alternately juxtaposed. The extension direction, size and number of the V-grooves and the prism-shaped ridges are not limited to those in Fig. 15, and can be appropriately set in accordance with, for instance, the emission characteristics required from the semiconductor light-emitting device, the optical characteristics of the light-transmitting substrate 13, and the emission characteristics of the phosphor layer. The sizes of the ridges 13d and V-grooves may be identical or dissimilar. The distribution of ridges 13d and V-grooves of dissimilar shapes can be appropriately set in accordance with, for instance, the emission characteristics required from the semiconductor light-emitting device, the optical characteristics of the light-transmitting substrate 13, and the emission characteristics of the phosphor layer.

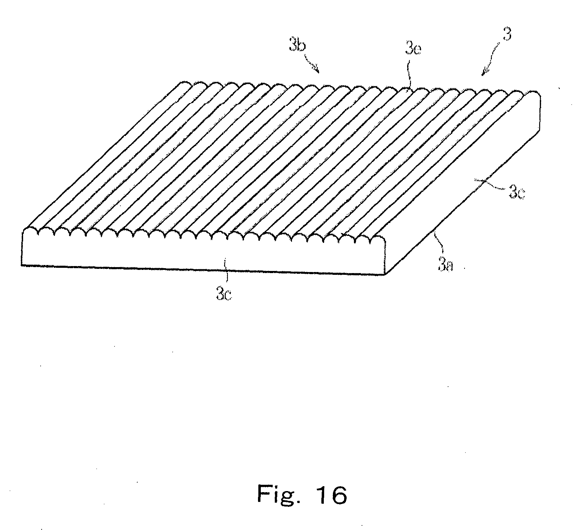

Fig. 16 is a perspective-view diagram illustrating an example of the light-transmitting substrate 13 wherein cylindrical prism shapes, instead of such V-groove/triangular prism shapes, are imparted to the second face 13b. In the example of Fig. 16, a plurality prism-shaped ridges 13e having a semicircular cross-sectional shape is formed parallelly. The extension direction, size and number of the prism-shaped ridges 13e having a semicircular cross-sectional shape are not limited to those of Fig. 16, and can be appropriately set in accordance with, for instance, the emission characteristics required from the semiconductor light-emitting device, the optical characteristics of the light-transmitting substrate 13, and the emission characteristics of the phosphor layer. The sizes of the ridges 13e may be identical or dissimilar. The distribution of ridges 13e of dissimilar shapes can be appropriately set in accordance with, for instance, the emission characteristics required from the semiconductor light-emitting device, the optical characteristics of the light-transmitting substrate 13, and the emission characteristics of the phosphor layer.

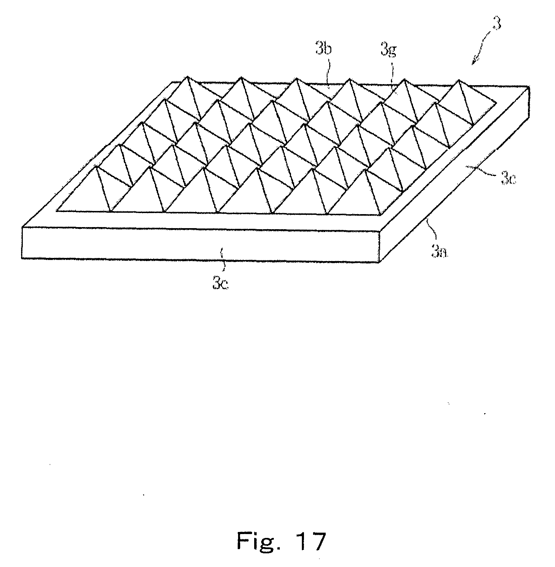

Fig. 17 is a perspective-view diagram illustrating an example of a light-transmitting substrate 13 in which a plurality of pyramidal protrusions 13g is formed on the second face 13b. In the example of Fig. 17, square pyramidal protrusions 13g of identical shape are arrayed regularly. The pyramids are not limited to square pyramids, and may be triangular, hexagonal pyramids, or circular cones. The number, positions and sizes of the pyramids are not limited to those in the example of Fig. 17, and can be appropriately set in accordance with, for instance, the emission characteristics required from the semiconductor light-emitting device, the optical characteristics of the light-transmitting substrate 13, and the emission characteristics of the phosphor layer. Also, the pyramids may be identical of dissimilar from each other. The distribution of dissimilar pyramids can be appropriately set in accordance with, for instance, the emission characteristics required from the semiconductor light-emitting device, the optical characteristics of the light-transmitting substrate 13, and the emission characteristics of the phosphor layer.

6-5-3. Condensing lenses

In a preferred form, the configuration of the remote phosphor is supplemented with condensing lenses that are provided on the light exit surface side of the phosphor layer. In a case where the phosphor layer is kneaded into the light-transmitting substrate, the condensing lenses are provided at the light exit surface side of the light-transmitting substrate that is the phosphor layer. In a case where the phosphor layer is provided on the semiconductor light-emitting element side of the light-transmitting substrate, the condensing lenses may be provided on the light exit surface side of the light-transmitting substrate, or may be provided as a separate member.

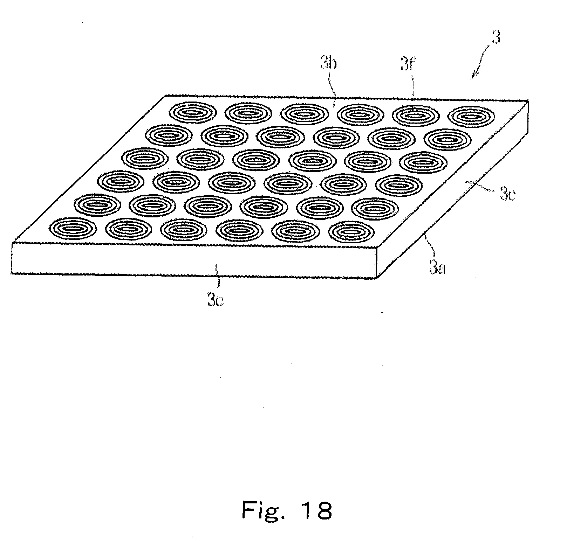

The condensing lenses may be formed as a result of a surface treatment of the light-transmitting substrate, or may be provided as a separate member. As an example of such a surface treatment for condensing light exiting outwards, Fig. 18 is a perspective-view diagram illustrating an example of the light-transmitting substrate 13 wherein a plurality of Fresnel lenses 13f is formed on the second face 13b. In the example of Fig. 18, identical Fresnel lenses are formed at positions so as to oppose cavities that are formed on the first face 13a of the light-transmitting substrate 13. The number, positions, sizes, optical characteristics and so forth of the Fresnel lenses are not limited to those in the example of Fig. 18, and can be appropriately set in accordance with, for instance, the emission characteristics required from the semiconductor light-emitting device, the optical characteristics of the light-transmitting substrate 13, and the emission characteristics of the phosphor layer. Also, convex lenses may be formed instead of Fresnel lenses. In this case as well, the number, positions, sizes, optical characteristics and so forth of the convex lenses can be appropriately set in accordance with, for instance, the emission characteristics required from the semiconductor light-emitting device, the optical characteristics of the light-transmitting substrate 13, and the emission characteristics of the phosphor layer.

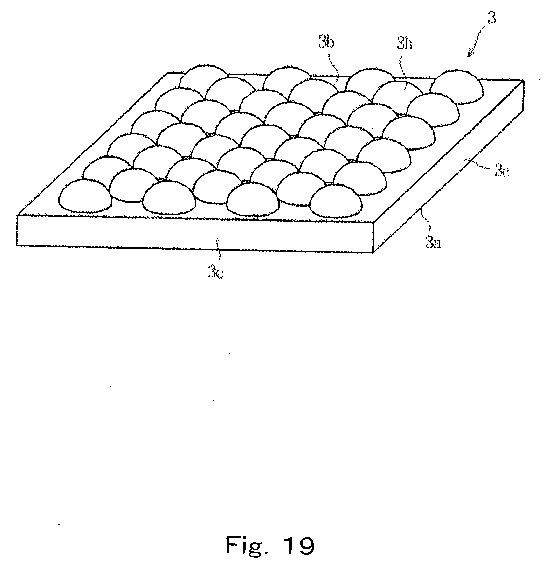

Fig. 19 is a perspective-view diagram illustrating an example of the light-transmitting substrate 13 wherein a plurality of semispherical protrusions 13h is formed on the second face 13b (fly-eye lens). In the example of Fig. 19, the semispherical protrusions 13h of identical shape are arrayed regularly. The number, positions, sizes and so forth of the semispherical protrusions 13h are not limited to those in the example of Fig. 19, and can be appropriately set in accordance with, for instance, the emission characteristics required from the semiconductor light-emitting device, the optical characteristics of the light-transmitting substrate 13, and the emission characteristics of the phosphor layer. The semispherical protrusions 13h may be not identical but dissimilar, and the distribution of dissimilar semispherical protrusions 13h can be appropriately set in accordance with, for instance, the emission characteristics required from the semiconductor light-emitting device, the optical characteristics of the light-transmitting substrate 13, and the emission characteristics of the phosphor layer.

6-6. White light

The light color of the white light emitted by the white light-emitting device according to the second aspect exhibits a deviation duv of -0.0200 to 0.0200 from a black body radiation locus. The definition of duv (= 1000duv) conforms to JIS Z 8725:1999 "Methods for Determining Distribution Temperature and Color Temperature or Correlated Color Temperature of Light Sources". White light is herein light that is encompassed within such ranges.

The color temperature of the white light emitted by the white light-emitting device according to the second aspect ranges from 1800 K to 7000 K. The white light emitted by the white light-emitting device according to the second aspect, lying within such a white range, is aimed at illumination applications, and can be clearly distinguished from that of light-emitting devices, for instance light-emitting devices for backlights.

Examples

The present invention will be explained in more detail on the basis of Experimental examples and comparative experimental examples. The present invention, however, is not limited to the experimental examples below, and may be modified in various ways without departing from the scope of the invention. The emission characteristics and so forth of the phosphors of the experimental examples and comparative experimental examples were measured in accordance with the methods described below.

<Chemical analysis>

A chemical analysis was performed on the basis of measurements by X-ray fluorescence, using samples fully dissolved in alkalis or the like.

<Emission spectrum>

Emission spectra were measured using a fluorescence measurement apparatus (by JASCO Corporation) equipped with a multichannel CCD detector C7041 (by Hamamatsu Photonics K. K.) as a spectrometer, and using a 150 W xenon lamp as an excitation light source.

Light from the excitation light source was caused to pass through a diffraction grating spectroscope at a focal distance of 10 cm, and only excitation light of wavelength 410 nm was irradiated onto the phosphor, via an optical fiber. The light generated by the phosphor as a result of being irradiated with the excitation light was split by a diffraction grating spectroscope at a focal distance of 25 cm, the emission intensity of each wavelength was measured by a spectrometer at a wavelength range from 300 nm to 800 nm. The results were subjected to signal processing, for instance, sensitivity correction, by a personal computer, to yield an emission spectrum. Measurements were performed by setting the slit width of the light-receiving side spectroscope to 1 nm.

<Chromaticity coordinates>

The chromaticity coordinates in an x, y color system (CIE 1931 color system) were calculated, according to the method of JIS Z8724, as chromaticity coordinate x and y in the XYZ color system defined in JIS Z8701, on the basis of data from a wavelength region from 420 nm to 800 nm in an emission spectrum obtained in accordance with the method described above.

<Temperature characteristics>

Temperature characteristics were measured in accordance with the below-described procedure using and an apparatus provided with a MCPD7000 multichannel spectrometer (by Otsuka Electronics), as the emission spectrometer, a luminance colorimeter as a luminance measurement device, a stage provided with a cooling mechanism based on a Peltier element, a heating mechanism relying on a heater, and a 150 W xenon lamp as a light source.

A cell holding a phosphor sample was placed on the stage, the temperature was changed step-wise over about 20°C, 25°C, 50°C, 75°C, 100°C, 125°C, 150°C and 175°C, and the surface temperature of the phosphor was checked. Next, the phosphor was excited with light of wavelength 410 nm that was extracted, split by a diffraction grating, out of the light source, and the luminance value and the emission spectrum were measured. The emission peak intensity was worked out from the measured emission spectrum. Herein, the value used as the measurement value of the surface temperature on the side of the excitation light irradiation of the phosphor was a value corrected by temperature measurement values from a radiation thermometer and a thermocouple.

Sedimentation rate

As regards the sedimentation rate, the ratio of sedimentation rates (sedimentation rate $v_s$ of the blue or red phosphor with respect to the sedimentation rate $v_s$ of the green phosphor) was calculated using the Stokes' equation (Stokes' law) on the basis of the density and particle size of the phosphors that were used.

[Formula 2]

$$v_s = \frac{D_p^2(\rho_p - \rho_f)g}{18\eta}$$

In the equation, $v_s$ denotes the sedimentation rate of the phosphor, Dp denotes the particle size of the phosphor, pp denotes the density of the phosphor particles, $\rho_f$ denotes the density of the light-transmitting material, and $\eta$ denotes the viscosity of a fluid (light-transmitting material).

<Production of the phosphor and emission characteristics of the produced phosphor>

Reference experimental example 1

Herein, $SrHPO_4$ (by Hakushin Chemical Laboratory Co., Ltd.), $SrCO_3$ (by Rare Metallic Co., Ltd, 99.99+%), $BaCO_3$ (by Rare Metallic, 99.99+%), $SrCl_2 \cdot 6H_2O$ (by Wako Pure Chemical, Ltd. 99.9%), $BaCl_2 \cdot 6H_2O$ (by Wako Pure Chemical, Ltd., special grade) and $Eu_2O_3$ (by Rare Metallic, 99.99%) were crushed and mixed with ethanol in an agate mortar so that the mole ratios thereof become 3:0.55:0.45:1:0:0.25; after drying, 4.0 g of the obtained crushed mixture were fired through heating for 3 hours at 1200°C under a nitrogen gas stream containing 4% of hydrogen, in an alumina crucible, followed by washing with water and drying, to produce thereby a phosphor $Eu_{0.5}Sr_{4.05}Ba_{0.45}(PO_4)_3Cl$. In the charge, 0.5 moles of excess $SrCl_2 + BaCl_2$ were included as fluxes. The composition formulas in Table 1 are corrected on the basis of a chemical analysis.

To mix the starting material compounds in the present experimental example, mixing was performed according to a wet mixing method using ethanol as a solvent, but mixing is not limited to such a method, so long as the starting material compounds can be sufficiently mixed. Phosphors of similar performance can be obtained also in accordance with a wet mixing method using water as a solvent, or in accordance with a dry mixing method.

Table 2 illustrates the emission characteristics (half width, luminance and so forth) of the phosphor compositions of Table 1 upon excitation of the phosphors at 410 nm, which is the dominant wavelength of a GaN-based light-emitting diode.

Table 1

| Nunber | Chemical composition of phosphor | | | |
|---|---|---|---|---|
| | Composition Formula | b/(a+b) | Ca substitution amount with respect to Sr (mol%) | x |
| Reference experimental ex. 1 | $Eu_{0.50}Sr_{4.05}Ba_{0.45}(PO_4)_3Cl$ | 0.10 | 0 | 0.50 |
| Experimental ex. 2 | $Eu_{0.50}Sr_{3.83}Ba_{0.67}(PO_4)_3Cl$ | 0.15 | 0 | 0.50 |
| Experimental ex. 3 | $Eu_{0.50}Sr_{3.78}Ba_{0.72}(PO_4)_3Cl$ | 0.16 | 0 | 0.50 |
| Experimental ex. 4 | $Eu_{0.50}Sr_{3.42}Ba_{1.08}(PO_4)_3Cl$ | 0.24 | 0 | 0.50 |
| Experimental ex. 5 | $Eu_{0.50}Sr_{2.97}Ba_{1.53}(PO_4)_3Cl$ | 0.34 | 0 | 0.50 |
| Reference experimental ex. 6 | $Eu_{0.50}Sr_{3.60}Ba_{0.45}Ca_{0.45}(PO_4)_3Cl$ | 0.10 | 11.1 | 0.50 |
| Experimental ex. 7 | $Eu_{0.45}Sr_{3.40}Ba_{0.65}(PO_4)_3Cl$ | 0.16 | 0 | 0.45 |
| Experimental ex. 8 | $Eu_{0.55}Sr_{3.74}Ba_{0.71}(PO_4)_3Cl$ | 0.16 | 0 | 0.55 |
| Experimental ex. 9 | $Eu_{0.65}Sr_{3.64}Ba_{0.70}(PO_4)_3Cl$ | 0.16 | 0 | 0.65 |
| Comparative Experimental ex. 1 | $Eu_{0.50}Sr_{4.50}(PO_4)_3Cl$ | 0 | 0 | 0.50 |
| Comparative Experimental ex. 2 | $Eu_{0.50}Sr_{4.28}Ba_{0.22}(PO_4)_3Cl$ | 0.05 | 0 | 0.50 |
| Comparative Experimental ex. 3 | $Eu_{0.50}Sr_{3.60}Ca_{0.90}(PO_4)_3Cl$ | 0 | 20.0 | 0.50 |
| Comparative Experimental ex. 4 | $Eu_{0.05}Sr_{4.16}Ba_{0.79}(PO_4)_3Cl$ | 0.16 | 0 | 0.05 |

Table 2

| Number | Emission characteristics | | | | | | | | |
|---|---|---|---|---|---|---|---|---|---|
| | Relative luminance with respect to SCA phosphor | Half width (nm) | Chromaticity coordinate x | Chromaticity coordinate y | Emission peak wavelength (nm) | Short wavelength-side half-value wavelength (nm) | Long wavelength-side half-value wavelength (nm) | Relative emission peak intensity with respect to SCA phosphor | I(490nm) /I(peak) |
| Reference experimental ex. 1 | 187 | 36 | 0.15 | 0.07 | 451 | 434 | 470 | 95 | 0.21 |
| Experimental ex. 2 | 251 | 43 | 0.15 | 0.10 | 451 | 430 | 477 | 81 | 0.34 |
| Experimental ex. 3 | 330 | 63 | 0.15 | 0.15 | 453 | 436 | 499 | 58 | 0.59 |
| Experimental ex. 4 | 409 | 79 | 0.15 | 0.21 | 468 | 437 | 516 | 47 | 0.85 |
| Experimental ex. 5 | 438 | 82 | 0.16 | 0.25 | 474 | 441 | 523 | 43 | 0.93 |
| Reference experimental ex. 6 | 291 | 57 | 0.15 | 0.15 | 454 | 436 | 493 | 55 | 0.53 |
| Experimental ex. 7 | 324 | 64 | 0.15 | 0.15 | 453 | 435 | 499 | 56 | 0.60 |
| Experimental ex. 8 | 336 | 65 | 0.15 | 0.16 | 454 | 436 | 501 | 56 | 0.62 |
| Experimental ex. 9 | 342 | 66 | 0.15 | 0.16 | 455 | 436 | 502 | 54 | 0.64 |
| Comp. experimental ex. 1 | 100 | 31 | 0.15 | 0.04 | 450 | 435 | 467 | 100 | 0.08 |
| Comp. experimental ex. 2 | 133 | 32 | 0.15 | 0.05 | 451 | 435 | 467 | 112 | 0.12 |

| Number | Emission characteristics | | | | | | | | |
|---|---|---|---|---|---|---|---|---|---|
| | Relative luminance with respect to SCA phosphor | Half width (nm) | Chromaticity coordinate x | Chromaticity coordinate y | Emission peak wavelength (nm) | Short wavelength-side half-value wavelength (nm) | Long wavelength-side half-value wavelength (nm) | Relative emission peak intensity with respect to SCA phosphor | I(490nm)/I(peak) |
| Comp. experimental ex. 3 | 188 | 37 | 0.15 | 0.08 | 453 | 437 | 474 | 85 | 0.22 |
| Comp. experimental ex. 4 | 93 | 40 | 0.15 | 0.06 | 445 | 428 | 468 | 50 | 0.19 |

EP 2 535 392 B1

Comparative experimental example 1

The same experiment as in Reference experimental example 1 was performed, but modifying the mole ratios of $SrHPO_4$, $SrCO_3$, $BaCO_3$, $SrCl_2 \cdot 6H_2O$, $BaCl_2 \cdot 6H_2O$ and $Eu_2O_3$ in the charge to 3:1:0:1:0:0.25. As a result there was obtained a phosphor (SCA phosphor) containing no Ba, denoted as Comparative experimental example 1 in Table 1. The emission characteristics of the phosphor are given in Table 2. In Reference experimental example 1, the luminance is 187 versus 100 and the half width is 36 versus 31 in Comparative experimental example 1. This indicates that the emission peak can be broadened towards longer wavelengths through incorporation of Ba. In the phosphor of Reference experimental example 1, where the b/(a+b) value is 0.10, the emission peak is broadened towards longer wavelengths thanks to the presence of Ba. Therefore, and although the emission peak wavelength does not vary virtually as compared with that of the SCA phosphor of Comparative experimental example 1 that contains no Ba, the I(490 nm)/I(peak) value is twice or greater that of the SCA phosphor of Comparative experimental example 1 (the emission spectrum is illustrated in Fig. 1).

The phosphor of Reference experimental example 1 has a higher luminance, of 87%, than that of the phosphor of Comparative experimental example 1. Therefore, this suggests that a light-emitting device having high luminance and excellent color rendering properties can be achieved in a case where the light-emitting device is a combination of luminescent bodies, such as LEDs, that employ the phosphor of Reference experimental example 1 instead of the SCA phosphor.

Experimental examples 2 to 5 and Comparative experimental example 2

Phosphors having b/(a+b) values ranging from 0.05 to 0.34 and denoted as Experimental examples 2 to 5 and Comparative experimental example 2 in Table 1 were obtained by performing the same experiment as in Reference experimental example 1, but modifying herein the charging mole ratios of $SrHPO_4$, $SrCO_3$, $BaCO_3$, $SrCl_2 \cdot 6H_2O$, $BaCl_2 \cdot 6H_2O$ and $Eu_2O_3$ in such a manner that the mole ratio of $SrCl_2 \cdot 6H_2O/BaCl_2 \cdot 6H_2O$ and the mole ratio of $SrCO_3/BaCO_3$ were identical and in such a manner that 0.5 moles of excess $SrCl_2 + BaCl_2$ were included as fluxes in the charge. The emission characteristics of the phosphors are given in Table 2.

In the Reference experimental example 1, and Experimental examples 2 to 5, Comparative experimental example 1 and Comparative experimental example 2 in Table 1 and Table 2, the value b/(a+b) varies while x is kept constant, for comparison purposes. Herein, "short wavelength-side half-value wavelength (nm)" denotes a short wavelength-side wavelength from among the wavelengths having half the intensity of the emission peak intensity, and "long wavelength-side half-value wavelength (nm)" denotes a long wavelength-side wavelength from among the wavelengths having half the intensity of the emission peak intensity.

It is found that when the b/(a+b) value is caused to vary from 0.10 to 0.34, the half width ranges from 36 to 82, higher than 31 in Comparative experimental example 1, and luminance ranges from 187 to 438, higher than 100 in Comparative experimental example 1. It was found, in particular, that half width and luminance increase as the Ba content increases.

It is found that when the b/(a+b) value is small, of 0.05, as in Comparative experimental example 2, the half width is 32, slightly higher than 31 in Comparative experimental example 1, and the luminance as well, at 133, is slightly higher than 100 in Comparative experimental example 1. The I(490 nm)/I(peak) value, at 0.12, was also slightly higher than 0.08 in Comparative experimental example 1.

It is found that, in Reference experimental example 1, and Experimental examples 2 to 5, an increase in the b/(a+b) value is accompanied by a proportionally greater increase in long wavelength-side half-value wavelength than that in the short wavelength-side half-value wavelength, and is accompanied by an increase in the I (490 nm) /I (peak) value and a significant increase in emission luminance.

Reference experimental example 6

The same experiment as in Reference experimental example 1 was performed, but modifying the mole ratios of $SrHPO_4$, $SrCO_3$, $BaCO_3$, $CaCO_3$ (by Hakushin), $SrCl_2 \cdot 6H_2O$, $BaCl_2 \cdot 6H_2O$ and $Eu_2O_3$ in the charge to 3:0.544:0.0056:0.45:0.5:0.5:0.5, to yield a phosphor denoted by Reference experimental example 6 in Table 1 and having a b/(a+b) value of 0.10 and a substitution amount of Ca with respect to Sr of 11.1 mol%. The emission characteristics of the phosphor are given in Table 2.

In this case, the half width was 57, higher than 31 in Comparative experimental example 1, and the luminance was 291, higher than 100 in the comparative example. This is attributable to the broadening of the emission spectrum towards the emission wavelength as a result of incorporation of Ba and Ca. In particular, it is deemed that incorporation of not only Ba but Ca as well results in emission at yet longer wavelengths, and higher luminance. The I (490 nm) /I (peak) value was large, and emission luminance likewise high. This is attributable to the contribution of not only Ba but Ca as well to broadening of the emission spectrum towards longer wavelengths.

Comparative experimental example 3

The same experiment as in Reference experimental example 1 was performed, but modifying the mole ratios of $SrHPO_4$, $SrCO_3$, $BaCO_3$, $CaCO_3$, $SrCl_2 \cdot 6H_2O$, $BaCl_2 \cdot 6H_2O$ and $Eu_2O_3$ in the charge to 3:0.1:0:0.9:1:0. A phosphor denoted by Comparative experimental example 3 in Table 1 was obtained that comprised no Ba and in which the Ca substitution amount with respect to Sr was 20.0 mol%. The emission characteristics of the phosphor are given in Table 2.
However, in a case where no Ba is present and 20.0 mol% of Sr are replaced by Ca, the half width is low, of 37, and luminance is likewise low, of 188. This can be attributed to the lack of sufficient broadening of emission, since, although Ca is present, Ba is not. The I(490 nm)/I(peak) value was smaller than that of the phosphor of Experimental example 6, and roughly identical to that of the phosphor of Experimental example 1. This indicates that the effect of adding Ca is weak unless Ba is added at the same time.

Experimental examples 7 to 9 and Comparative experimental example 4

Phosphors having an x value ranging from 0.05 to 0.65 and denoted as Experimental examples 7 to 9 and Comparative experimental example 4 in Table 1 were obtained by performing the same experiment as in Reference experimental example 1, but modifying herein the charging mole ratios of $SrHPO_4$, $SrCO_3$, $BaCO_3$, $SrCl_2 \cdot 6H_2O$, $BaCl_2 \cdot 6H_2O$, $Eu_2O_3$ in such a manner that the mole ratio of $SrCl_2 \cdot 6H_2O/BaCl_2 \cdot 6H_2O$ was constant and in such a manner that 0.5 moles of excess $SrCl_2+BaCl_2$ were included as fluxes in the charge. The emission characteristics of the phosphors are given in Table 2.
In Experimental examples 7, 3, 8, 9 and Comparative experimental example 4 in Table 1 and Table 2, the value x varies while b/ (a+b) is kept constant, for comparison purposes. It is found that when x ranges from 0.45 to 0.65, the half width ranges from 63 to 66, which is remarkably higher than 31 in Comparative experimental example 1, and luminance ranges from 324 to 342, which is remarkably higher than 100 in Comparative experimental example 1. In particular, it was found that luminance increased accompanying increases in Eu content. This is attributable to the tendency of emission peak wavelength and half width to become greater as a result of an increase of the Eu content. Luminance decreased in a phosphor having a low x value, of 0.05, even though the b/(a+b) value was likewise 0.16, as in Comparative experimental example 4. When the Eu content is small, half width becomes very small and emission peak intensity decreases, even if a predetermined amount of Ba is present. Therefore, the luminance, of 93, is very low compared to 100 in Comparative experimental example 1. It is deemed that using the phosphor of Comparative experimental example 4 in a light-emitting device would result in low emission efficiency.

<Temperature characteristics of the phosphors>

Table 3 shows results of measurements of the temperature dependence of the emission peak intensity and the temperature dependence of the emission luminance of the phosphors of Reference experimental examples 1 and 6, and Experimental examples 3, 5, 7 and 9 and Comparative experimental examples 1, 3 and 4. The temperature dependence of the emission peak intensity denotes a relative value with respect to 100 as the value for each phosphor at room temperature. The temperature dependence of emission luminance denotes a relative value with respect to 100 as the value of the luminance of the phosphor of Comparative experimental example 1 at room temperature.
As Table 3 shows, the relative emission peak intensity at high temperature (80°C, 100°C and 130°C) took on greater values in the phosphors of Reference experimental examples 1 and 6, and Experimental examples 3, 5, 7 and 9, which contained Ba, than in the phosphors of Comparative experimental examples 1 and 3, which contained no Ba. It is found that emission intensity and luminance at 80°C, 100°C and 130°C are higher in phosphors having a b/(a+b) value ranging from 0.10 to 0.34, as compared with Comparative experimental examples 1 and 3, which contain no Ba; that is, emission intensity retention and luminance, at high temperatures of 80 to 130°C reached during LED operation, are remarkably high. The Ba substitution effect is borne thus out. It was further found that luminance at 80°C, 100°C and 130°C became remarkably high through an increase in Eu concentration, and that high-concentration Eu-activated Sr-Ba apatite is very effective in practice. The phosphor of Reference experimental example 6, comprising Ba and having part of Sr replaced by Ca, exhibited a greater drop rate of relative emission peak intensity and luminance at high temperature than in the case of other phosphors comprising Ba. The phosphor of Comparative experimental example 3, comprising no Ba and having part of Sr replaced by Ca, exhibited the greater drop in relative emission peak intensity at high temperature next to that of the phosphor of Comparative experimental example 1.
In Comparative experimental example 4 having low Eu concentration, luminance at 80°C, 100°C and 130°C was very low, as in Comparative experimental example 1. It is deemed that using the phosphor of Comparative experimental example 4 in a light-emitting device should result in low emission efficiency upon rises in the temperature of the device after prolonged use.

A comparison between the phosphors of Experimental examples 3, 7 and 9 having the same b/(a+b) value but dissimilar x values revealed that the extent of drop in relative emission peak intensity at high temperature was substantially the same, but the phosphor of Experimental example 9, where the x value was 0.65, exhibited a greater drop in luminance at high temperature than the other two phosphors.

In a light-emitting device in which a phosphor having high emission intensity retention at high temperature is combined with a luminous body such as an LED, it becomes possible to suppress fluctuation in emission intensity from the device, even when the temperature of the device rises after prolonged use, and it becomes possible to suppress the occurrence of color shift. In particular, it is deemed that problems such as color shift and/or drops in emission intensity should be less likely to occur, even as a result of heat generation during energization, also in a light-emitting device of a combination with a power device, such as a large chip, capable of high output.

Table 3

| Number | Chemical composition of phosphor | Relative emission peak intensity at each temperature (value at room temperature = 100%) | | | | Relative luminance at each temperature (luminance of SCA phosphor at room temperature = 100) | | | |
|---|---|---|---|---|---|---|---|---|---|
| | Composition formula | Room temperature | 80 °C | 100 °C | 130 °C | Room temperature | 80 °C | 100 °C | 130 °C |
| Reference experimental ex. 1 | $Eu_{0.50}Sr_{4.05}Ba_{0.45}(PO_4)_3Cl$ | 100 | 81 | 75 | 65 | 187 | 181 | 175 | 160 |
| Experimental ex. 3 | $Eu_{0.50}Sr_{3.78}Ba_{0.72}(PO_4)_3Cl$ | 100 | 88 | 83 | 70 | 330 | 312 | 290 | 237 |
| Experimental ex. 5 | $Eu_{0.50}Sr_{2.97}Ba_{1.53}(PO_4)_3Cl$ | 100 | 92 | 87 | 73 | 438 | 418 | 393 | 322 |
| Reference experimental ex. 6 | $Eu_{0.50}Sr_{3.60}Ba_{0.45}Ca_{0.45}(PO_4)_3Cl$ | 100 | 80 | 74 | 63 | 291 | 266 | 245 | 200 |
| Experimental ex. 7 | $Eu_{0.45}Sr_{3.40}Ba_{0.65}(PO_4)_3Cl$ | 100 | 87 | 82 | 70 | 324 | 304 | 283 | 237 |
| Experimental ex. 9 | $Eu_{0.65}Sr_{3.65}Ba_{0.70}(PO_4)_3Cl$ | 100 | 88 | 82 | 70 | 342 | 300 | 272 | 222 |
| Comp. experimental ex. 1 | $Eu_{0.50}Sr_{4.50}(PO_4)_3Cl$ | 100 | 73 | 65 | 53 | 100 | 90 | 85 | 74 |
| Comp. experimental ex. 3 | $Eu_{0.50}Sr_{3.60}Ca_{0.90}(PO_4)_3Cl$ | 100 | 76 | 69 | 57 | 188 | 179 | 172 | 151 |
| Comp. experimental ex. 4 | $Eu_{0.05}Sr_{4.16}Ba_{0.79}(PO_4)_3Cl$ | 100 | 84 | 79 | 70 | 93 | 109 | 112 | 109 |

<Production of other phosphors; emission characteristics and temperature characteristics of the produced phosphors>

Experimental example 10, Experimental example 11, Experimental example 12, Comparative experimental example 5

Phosphors having x values of 0.32, 0.38, 0.95 and 0.25 and denoted as Experimental examples 10 to 12 and Comparative experimental example 5 in Table 4 were obtained by performing the same experiment as in Experimental example 1, but modifying herein the charging mole ratios of $SrHPO_4$, $SrCO_3$, $BaCO_3$, $SrCl_2 \cdot 6H_2O$, $BaCl_2 \cdot 6H_2O$ and $Eu_2O_3$ in such a manner that the mole ratio of $SrCl_2 \cdot 6H_2O/BaCl_2 \cdot 6H_2O$ was constant and in such a manner that 0.5 moles of excess $SrCl_2+BaCl_2$ were included as fluxes in the charge. The emission characteristics of the phosphors are given in Table 5.

Table 4

| Number | Chemical composition of phosphor | | | |
|---|---|---|---|---|
| | Composition formula | b/(a+b) | Ca substitution amount with respect to Sr (mol%) | x |
| Experimental ex. 10 | $Eu_{0.32}Sr_{3.74}Ba_{0.94}(PO_4)_3Cl$ | 0.16 | 0 | 0.32 |
| Experimental ex. 11 | $Eu_{0.38}Sr_{3.70}Ba_{0.92}(PO_4)_3Cl$ | 0.16 | 0 | 0.38 |
| Experimental ex. 12 | $Eu_{0.95}Sr_{3.24}Ba_{0.81}(PO_4)_3Cl$ | 0.16 | 0 | 0.95 |
| Comp. experimental ex. 5 | $Eu_{0.25}Sr_{3.80}Ba_{0.95}(PO_4)_3Cl$ | 0.16 | 0 | 0.25 |

Table 5

| Number | Emission characteristics | | | | | | | | |
|---|---|---|---|---|---|---|---|---|---|
| | Relative luminance with respect to SCA phosphor | Half width (nm) | Chromaticity coordinate x | Chromaticity coordinate y | Emission peak wavelength (nm) | Short wavelength-side half-value wavelength (nm) | Long wavelength-side half-value wavelength (nm) | Relative emission peak intensity with respect to SCA phosphor | I(490nm) /I(peak) |
| Experimental ex. 10 | 261 | 50 | 0.150 | 0.118 | 450 | 433 | 484 | 60 | 0.42 |
| Experimental ex. 11 | 296 | 54 | 0.150 | 0.129 | 450 | 433 | 488 | 60 | 0.48 |
| Experimental ex. 12 | 386 | 65 | 0.153 | 0.166 | 452 | 436 | 500 | 57 | 0.61 |
| Comp. experimental ex. 5 | 241 | 47 | 0.150 | 0.109 | 449 | 432 | 479 | 62 | 0.38 |

Table 6 shows results of measurements of the temperature dependence of the emission peak intensity and the temperature dependence of the emission luminance of the phosphors of Experimental examples 10 to 12 and Comparative experimental example 5 . The temperature dependence of the emission peak intensity denotes a relative value with respect to 100 as the value for each phosphor at room temperature. The temperature dependence of emission luminance denotes a relative value with respect to 100 as the value of the luminance of the phosphor of Comparative experimental example 1 at room temperature.

Table 6

| Number | Relative emission peak intensity at each temperature (value at room temperature = 100%) | | | | Relative luminance at each temperature (luminance of SCA phosphor at room temperature = 100) | | | |
|---|---|---|---|---|---|---|---|---|
| | Room temperature | 80 °C | 100 °C | 130 °C | Room temperature | 80 °C | 100 °C | 130 °C |
| Experimental ex. 10 | 100 | 96 | 91 | 80 | 261 | 243 | 233 | 204 |
| Experimental ex. 11 | 100 | 92 | 87 | 74 | 296 | 263 | 248 | 211 |
| Experimental ex. 12 | 100 | 84 | 75 | 60 | 386 | 282 | 240 | 186 |
| Comp. experimental ex. 5 | 100 | 101 | 99 | 89 | 241 | 244 | 242 | 221 |

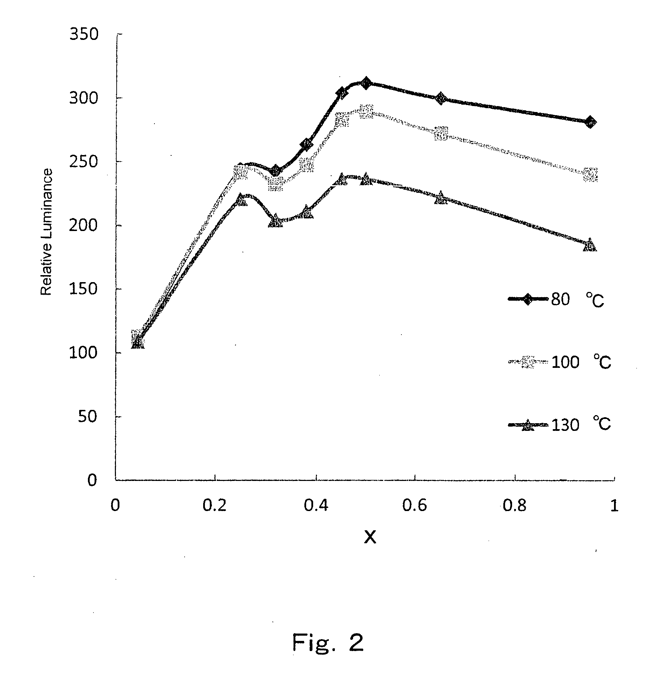

Fig. 2 summarizes the results of emission luminance at 80°C, 100°C and 130°C of the phosphors of Experimental example 3, Experimental examples 7 to 12 and Comparative experimental example 5. In the light of Fig. 2, it was found that when the Eu mole ratio x was about 0.25, the relative luminance took on a maximum value that was nonetheless comparatively low, between 80°C to 130°C, as the temperature region reached during LED operation; whereas when x was about 0.5, at which Eu was in very high concentration, the relative luminance took on a maximum value that was also the largest value.

Experimental example 13, Experimental example 14, Comparative experimental example 6, Comparative experimental example 7

A warm-white light-emitting device was manufactured using the phosphor of Experimental example 3 or the SCA phosphor of Comparative experimental example 1, and the temperature characteristics were evaluated. To manufacture the device, one InGaN-based near-ultraviolet LED chip was packaged in a 3528 SMD-type PPA resin package, and was encapsulated using a phosphor-containing composition in which a blue phosphor (phosphor of Experimental example 3 or SCA phosphor of Comparative experimental example 1) a green phosphor and a red phosphor were dispersed in a silicone resin (produced in accordance with Example 1 described in JP-A-2009-23922). A BSS phosphor (produced in accordance with Example 1 described in WO 2007-09187) was used as the green phosphor, and a CASON phosphor (produced in accordance with Example I-3 described in JP-A-2007-231245) was used as the red phosphor. Table 7 sets out the emission peak wavelength of the near-ultraviolet LED chip and phosphor blending ratio, as well as the chromaticity coordinate values and temperature characteristics upon application of a 20 mA current, of the various white light-emitting devices thus manufactured. The phosphor blending ratio in Table 7 denotes weight % with respect to the phosphor-containing composition.

Table 7

| Experimental ex. or Comp. experimental ex | Emission peak wavelength of near-UV LED chip (nm) | Type of blue phosphor | Phosphor blending ratio (wt%) | | | Chromaticity coordinate values | | Temperature characteristics |
|---|---|---|---|---|---|---|---|---|
| | | | Blue phosphor | BSS phosphor | CASON phosphor | x | y | Emission efficiency ratio (%) |
| Experimental ex. 13 | 411 | Phosphor of Experimental ex. 3 | 3.2 | 1.9 | 5.6 | 0.43 | 0.40 | 92 |
| Comp. experimental ex. 6 | 411 | Phosphor of Comp. experimental ex. 1 | 6.2 | 2.9 | 5.4 | 0.43 | 0.40 | 86 |
| Experimental ex. 14 | 406 | Phosphor of Experimental ex. 3 | 3.6 | 1.1 | 5.0 | 0.44 | 0.40 | 78 |
| Comp. experimental ex. 7 | 406 | Phosphor of Comp. experimental ex. 1 | 6.5 | 2.6 | 5.4 | 0.44 | 0.40 | 72 |

The emission efficiency ratio in Table 7 denotes the ratio of the emission efficiency (luminous flux per input power into the near-ultraviolet LED chip) at 80°C with respect to the emission efficiency at 25°C. The white light-emitting devices (Experimental example 13, Experimental example 14) that used the phosphor of the present invention (phosphor of Experimental example 3) as the blue phosphor were superior to white light-emitting devices (Comparative experimental example 6, Comparative experimental example 7) that used the SCA phosphor, both when the emission peak wavelength of the near-ultraviolet LED chip used as an excitation source was 411 nm and 406 nm. The white LEDs of Experimental example 13 and Experimental example 14 exhibited excellent color rendering properties, namely a general color rendering index (Ra) of 95 and 97, respectively.

Experimental example 15

A day-white LED was produced using a InGaN-based near-ultraviolet LED chip, the halophosphate phosphor (blue phosphor) of Experimental example 3, the β-SiAlON phosphor (green phosphor) and CASON phosphor (red phosphor). The β-SiAlON phosphor that was used had an emission peak wavelength of 542 nm when excited with light of wavelength 400 nm, and exhibited a half width of the emission peak of 56 nm. The CASON phosphor that was used had an emission peak wavelength of 643 nm when excited with light of wavelength 405 nm, and exhibited a half width of the emission peak of 116 nm.

The ratio of the sedimentation rate of the halophosphate phosphor (blue phosphor) of Experimental example 3 with respect to that of the β-SiAlON phosphor (green phosphor) was 0.86, and the ratio of the sedimentation rate of the CASON phosphor (red phosphor) with respect to that of the β-SiAlON phosphor (green phosphor) was 1.12. The density of the halophosphate phosphor (blue phosphor) of Experimental example 3 was 4.5 g/cm$^3$, the density of the β-SiAlON phosphor (green phosphor) was 3.2 g/cm$^3$ and the density of the CASON phosphor (red phosphor) was 3.2 g/cm$^3$.

An evaluation of the produced light-emitting device revealed that chromaticity variability in the light-emitting device was 0.002 or less at a chromaticity point in xy coordinates. The obtained light-emitting device exhibited also high durability in the below-described comparative reference example.

Comparative reference example

A day-white white LED was produced using an InGaN-based near-ultraviolet LED chip, a BAM phosphor (blue phosphor), a BSS phosphor (green phosphor) and a CASON phosphor (red phosphor). The BSS phosphor that was used had an emission peak wavelength of 525 nm and a half width of the emission peak of 68 nm when excited with light of wavelength 400 nm. The CASON phosphor that was used had an emission peak wavelength of 643 nm and a half width of the emission peak of 116 nm when excited with light of wavelength 405 nm. The ratio of the sedimentation rate of the BAM phosphor (blue phosphor) with respect to that of the BSS phosphor (green phosphor) was 0.43, and the ratio of the sedimentation rate of the CASON phosphor (red phosphor) with respect to that of the BSS phosphor (green phosphor) was 0.56. The density of the BAM phosphor (blue phosphor) was 3.8 g/cm$^3$, the density of the BSS phosphor (green phosphor) was 5. 4 g/cm$^3$ and the density of the CASON phosphor (red phosphor) was 3.2 g/cm$^3$. The chromaticity coordinates values at an emission peak wavelength of 406 nm of the near-ultraviolet LED chip in the white light-emitting devices that were produced were x = 0.461 and y = 0.408, upon application of a current of 20 mA. Chromaticity variability was about 0.008 at a chromaticity point in the xy coordinates.

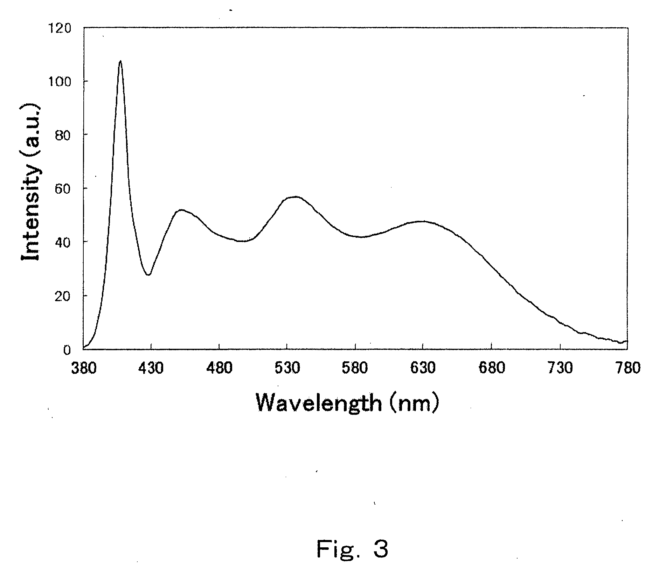

To manufacture a white LED, one 350 μm square LED chip was packaged in a 3528 SMD-type PPA resin, and was encapsulated with a silicone resin having dispersed therein the above-described various phosphors in microparticle form. Table 8 sets out the emission peak wavelength of the near-ultraviolet LED chip that was used, the blending ratio of the phosphors added to the silicone resin, as well as the Tcp (correlated color temperature), the chromaticity coordinate values, the general color rendering index Ra and the special color rendering index R12 upon application of a 20 mA current to the manufactured white LED. Fig. 3 illustrates the emission spectrum of the manufactured white LED upon application of a 20 mA current. The phosphor blending ratios given in Table 8 denote the weight ratio of each phosphor with respect to the mixture of silicone resin and phosphors.

Table 7

| Number | Emission peak wavelength of near-UV LED chip (nm) | Phosphor blending ratio (wt%) | | | Tcp [K] | Chromaticity coordinate values | | Ra | R12 |
|---|---|---|---|---|---|---|---|---|---|
| | | Blue phosphore | Green phosphor | Red phosphor | | x | y | | |
| Experimental ex. 15 | 406 | 4.7 | 1.8 | 2.4 | 5610 | 0.330 | 0.346 | 95 | 92 |
| Experimental ex. 16 | 406 | 4.6 | 2.0 | 2.3 | 5568 | 0.331 | 0.348 | 95 | 86 |
| Experimental ex 17 | 406 | 4.9 | 0.9 | 2.4 | 5537 | 0.331 | 0.351 | 95 | 89 |
| Experimental ex. 18 | 406 | 5.6 | 0.7 | 2.2 | 5491 | 0.329 | 0.361 | 94 | 84 |
| Experimental ex. 19 | 407 | 4.6 | 1.3 | 2.4 | 5565 | 0.331 | 0.346 | 97 | 95 |
| Experimental ex. 20 | 407 | 4.6 | 1.4 | 2.4 | 5537 | 0.332 | 0.351 | 98 | 97 |
| Experimental ex. 21 | 406 | 3.6 | 1.8 | 4.9 | 3085 | 0.429 | 0.399 | 96 | 92 |
| Comp. experimental ex. 8 | 406 | 13.0 | 1.7 | 1.5 | 5495 | 0.333 | 0.345 | 92 | 81 |

Comparative experimental example 8

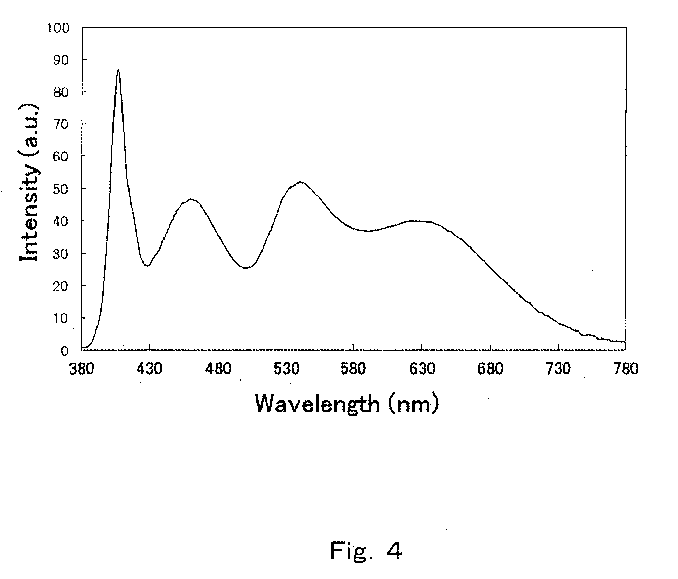

A day-white LED was produced in the same way as in Experimental example 15, but using herein the BAM phosphor as the blue phosphor, instead of the halophosphate phosphor of Experimental example 3. The BAM phosphor that was used had an emission peak wavelength of 455 nm when excited with light of wavelength 400 nm, and exhibited a half width of the emission peak of 53 nm. Table 8 sets out the emission peak wavelength of the near-ultraviolet LED chip that was used, the blending ratio of the phosphors added to the silicone resin, as well as the Tcp (correlated color temperature), the chromaticity coordinate values, the general color rendering index Ra and the special color rendering index R12 upon application of 20 mA current to the manufactured white LED. Fig. 4 illustrates the emission spectrum of the manufactured white LED upon application of a 20 mA current.

The emission spectrum of the BAM phosphor used in Comparative experimental example 8 when excited with light of wavelength 400 nm exhibited a short wavelength-side half-value wavelength of 434 nm, a long wavelength-side half-value wavelength of 487 nm, and a ratio of 0.45 of emission intensity at wavelength 490 nm with respect to the emission peak intensity.

Experimental example 16

A day-white LED was produced as a halophosphate phosphor in the same way as in Experimental example 15, but using herein a halophosphate phosphor of a composition formula $(Sr_{3.96}Ba_{0.54}Eu_{0.5}(PO_4)_3Cl)$, having a b/(a+b) value of 0.12, a substitution amount of Ca with respect to Sr of 0 mol% and an x value of 0.50, in place of the halophosphate phosphor (blue phosphor) in Experimental example 3. Table 8 sets out the emission peak wavelength of the near-ultraviolet LED chip that was used, the blending ratio of the phosphors added to the silicone resin, as well as the Tcp (correlated color temperature), the chromaticity coordinate values, the general color rendering index Ra and the special color rendering index R12 upon application of 20 mA current to the manufactured white LED.

Experimental example 17

A day-white LED was produced in the same way as in Experimental example 15, but using herein the halophosphate phosphor (blue phosphor) of Experimental example 4 as the blue phosphor, instead of the halophosphate phosphor (blue phosphor) of Experimental example 3. Table 8 sets out the emission peak wavelength of the near-ultraviolet LED chip that was used, the blending ratio of the phosphors added to the silicone resin, as well as the Tcp (correlated color temperature), the chromaticity coordinate values, the general color rendering index Ra and the special color rendering index R12 upon application of 20 mA current to the manufactured white LED.

Experimental example 18

A day-white LED was produced in the same way as in Experimental example 15, but using herein the halophosphate phosphor (blue phosphor) of Experimental example 5 as the blue phosphor, instead of the halophosphate phosphor (blue phosphor) of Experimental example 3. Table 8 sets out the emission peak wavelength of the near-ultraviolet LED chip that was used, the blending ratio of the phosphors added to the silicone resin, as well as the Tcp (correlated color temperature), the chromaticity coordinate values, the general color rendering index Ra and the special color rendering index R12 upon application of 20 mA current to the manufactured white LED.

Experimental example 19

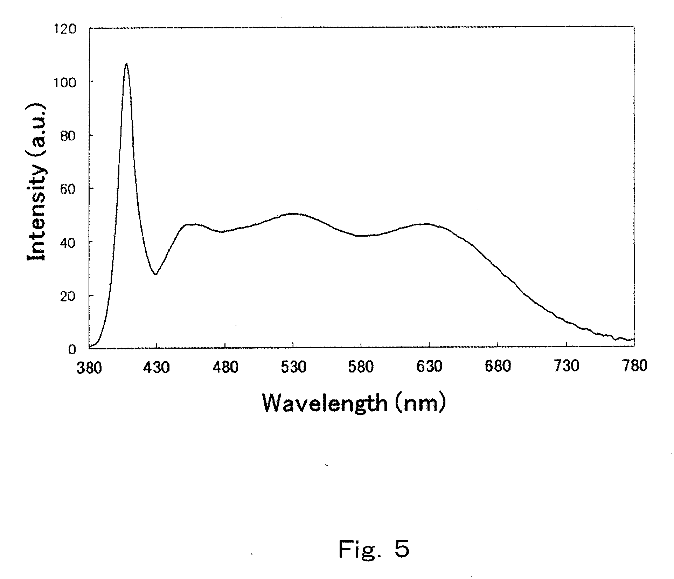

A day-white LED was produced in the same way as in Experimental example 15, but using herein, as the green phosphor, the BSON phosphor instead of the β-SiAlON phosphor. The BSON phosphor that was used had an emission peak wavelength of 535 nm when excited with light of wavelength 405 nm, and exhibited a half width of the emission peak of 71 nm. Table 8 sets out the emission peak wavelength of the near-ultraviolet LED chip that was used, the blending ratio of the phosphors added to the silicone resin, as well as the Tcp (correlated color temperature), the chromaticity coordinate values, the general color rendering index Ra and the special color rendering index R12 upon application of 20 mA current to the manufactured white LED. Fig. 5 illustrates the emission spectrum of the manufactured white LED upon application of a 20 mA current.

Experimental example 20

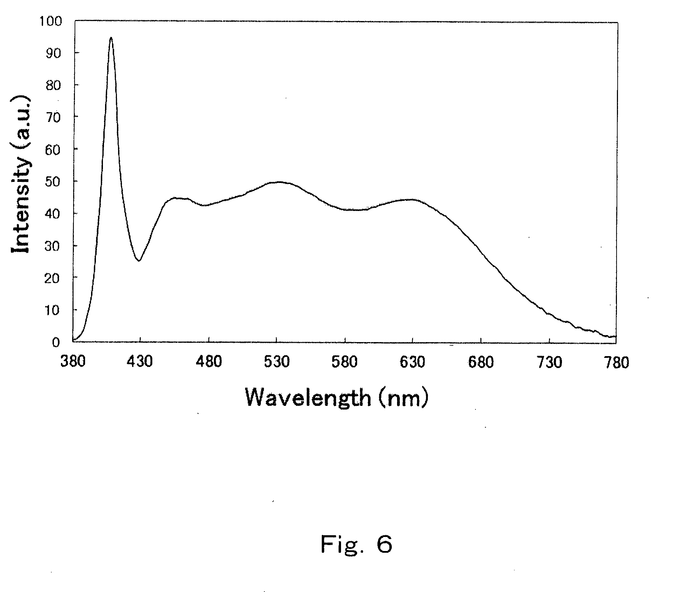

A day-white LED was produced in the same way as in Experimental example 15 but using herein, as the green phosphor, a BSON phosphor having an emission peak wavelength of 536 nm when excited with light of wavelength 405 nm and having a half width of emission peak of 72 nm. Table 8 sets out the emission peak wavelength of the near-ultraviolet LED chip that was used, the blending ratio of the phosphors added to the silicone resin, as well as the Tcp (correlated color temperature), the chromaticity coordinate values, the general color rendering index Ra and the special color rendering index R12 upon application of 20 mA current to the manufactured white LED. Fig. 6 illustrates the emission spectrum of the manufactured white LED upon application of a 20 mA current.

Experimental example 21

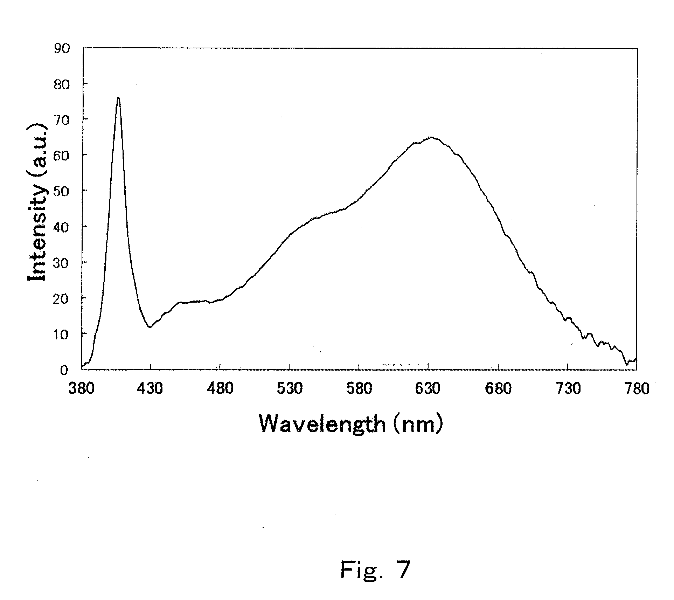

A warm-white LED was produced using a blue phosphor, green phosphor and red phosphor identical to those of Experimental example 16. The production sequence of the white LED was identical to that of Experimental example 15. Table 8 sets out the emission peak wavelength of the near-ultraviolet LED chip that was used, blending ratio of the phosphors added to the silicone resin, as well as the Tcp (correlated color temperature), the chromaticity coordinate values, the general color rendering index Ra and the special color rendering index R12 upon application of 20 mA current to the manufactured white LED. Fig. 7 illustrates the emission spectrum of the manufactured white LED upon application of a 20 mA current.

As Table 8 shows, the white LEDs of Experimental examples 15, 19, 20 and 21 had a value of general color rendering index Ra of 95 or greater, and a special color rendering index R12 higher than 90. The white LEDs of Experimental examples 16, 17 and 18 had a value of general color rendering index Ra of 94 or greater, and a high special color rendering index R12, of 84 or higher. By contrast, the white LED of Comparative experimental example 8 had a general color rendering index Ra of 90 or greater, but a special color rendering index R12 of 81.

Experimental examples 15 and 19 to 21, where the phosphor of Experimental example 3, having b/(a+b)= 0.16, was used as an example of the halophosphate phosphor (blue phosphor), exhibited a very high R12 value, of 90 or greater. In Experimental examples 16 to 18, where b/(a+b) was caused to vary from 0.12 to 0.34, the value of R12 was high, of 84 or greater. Thus, the R12 of the white light-emitting device can be caused to take on a good value by using a halophosphate phosphor having a b/(a+b) value that ranges from 0.12 to 0.40.

INDUSTRIAL APPLICABILITY

The use of the phosphor of the present invention is not particularly limited, and the phosphor may be used in various fields in which ordinary phosphors are utilized. By virtue of characteristics such as large half width of the emission peak as well as excellent temperature characteristics, the phosphor of the present invention is suitable for the purpose of realizing a luminous body for ordinary illumination in which the phosphor is excited by a light source such as a near-ultraviolet LED.

The light-emitting device of the present invention that uses the phosphor of the present invention having characteristics such as the above-described ones can be used in various fields in which ordinarily light-emitting devices are utilized, but is particularly suitable for use as a light source in image display devices and illumination devices.

In 1986, CIE (International Commission on Illumination) published guidelines on the color rendering properties of fluorescent lamps. According to these guidelines, the preferred general color rendering index (Ra) according to the site where illumination is utilized ranges from 60 to less than 80 in factories where ordinary work is performed, from 80 to less than 90 in homes, hotels, restaurants, shops, offices, schools, hospitals and factories where precision work is performed, and 90 or more in clinical testing sites, museums and the like. The illumination device using the white light-emitting device according to the present invention can be preferably used as illumination for any of the foregoing facilities.

Description of the reference numerals

| 1 | light-emitting device |
| 2 | semiconductor light-emitting element |
| 3 | package |
| 4 | phosphor layer |
| 5 | light-transmitting substrate |
| 6a | first light-emitting member |
| 6b | second light-emitting member |
| 6c | third light-emitting member |
| 9 | band pass filter |
| 13 | light-transmitting substrate |
| 13a | first face |
| 13b | second face |
| 13c | third face |
| 13d, 13e | ridge |
| 13f | Fresnel lens |
| 13g | pyramidal protrusion |
| 13h | semispherical protrusion |

**Claims**

1. A white light-emitting device of a phosphor conversion-type comprising a semiconductor light-emitting element that emits light in a near-ultraviolet wavelength region, and a phosphor which converts wavelength of light emitted by the semiconductor light-emitting element to generate white light, wherein

   the phosphor includes a blue phosphor having a chemical composition of formula [1] below, a green phosphor having an emission peak wavelength of 535 nm or greater, and at least one type of red phosphor selected from among an Eu-activated nitride phosphor and an Eu-activated oxynitride phosphor, and

   white light emitted by the white light-emitting device has a color temperature ranging from 1800 K to 7000 K;

$$(Sr, Ca)_a Ba_b Eu_x (PO_4)_c X_d, \qquad [1]$$

   (In general formula [1'], X is Cl; c, d and x are numbers satisfying $2.7 \leq c \leq 3.3$, $0.9 \leq d \leq 1.1$ and $0.3 \leq x \leq 1.2$; and a and b satisfy the conditions $a+b = 5-x$ and $0.12 \leq b/(a+b) \leq 0.4$ and (Sr, Ca) means that the phosphor contains either both Sr and Ca or Sr alone.).

2. The white light-emitting device according to claim 1, wherein light color of the white light emitted by the white light-emitting device exhibits a deviation duv of -0.0200 to 0.0200 from a black body radiation locus as defined by JIS Z8725:1999.

3. The white light-emitting device according to claim 1 or 2, wherein the green phosphor has an emission peak wavelength ranging from 535 to 545 nm and an emission peak half width ranging from 55 to 70 nm, the blue phosphor has an emission peak wavelength ranging from 450 to 460 nm, and an I (490 nm) /I (peak) value, in which I(peak) denotes an intensity of the emission peak wavelength and 1 (490 nm) denotes an intensity at wavelength 490 nm in an emission spectrum of the blue phosphor upon excitation with light of wavelength 410 nm, ranges from 0.55 to 0.65.

4. The white light-emitting device according to any one of claims 1 to 3, wherein the green phosphor has an emission peak wavelength ranging from 535 to 545 nm and an emission, peak half width ranging from 55 to 70 nm, and blue phosphor having a composition which is represented by the general formula [1] with the b/ (a+b) value ranging from 0. 15 to 0.20, where the metal element is essentially Sr, Eu and Ba alone.

5. The white light-emitting device according to any one of claims 1 to 4, wherein the green phosphor includes an Eu-activated oxynitride phosphor.

6. The white light-emitting device according to any one of claims 1 to 5, wherein the red phosphor includes a CASON phosphor.

7. The white light-emitting device according to any one of claims 1 to 6, wherein a general color rendering index Ra and a special color rendering index R12 are both 90 or greater.

8. The white light-emitting device according to claim 1, wherein the green phosphor is an Eu-activated oxynitride phosphor, and the blue phosphor has a composition which is represented by the general formula [1] with the b/(a+b) value ranging from 0.16 to 0.40, where the metal element is essentially Sr, Eu and Ba alone.

9. The white light-emitting device according to claim 8, wherein the value of x in formula [1] ranges from 0.3 to less than 0.65.

10. The white light-emitting device according to any one of claims 1 to 9, wherein the blue phosphor, the green phosphor and the red phosphor are dispersed in a light-transmitting resin material and are encapsulated thereafter in the white light-emitting device, such that a ratio of a sedimentation rate of the blue phosphor in the light-transmitting resin material with respect to that of the green phosphor ranges from 0.70 to 1.30.

11. The white light-emitting device according to any one of claims 1 to 10, wherein the blue phosphor, the green phosphor and the red phosphor are dispersed in a light-transmitting resin material and are encapsulated thereafter in the white light-emitting device, such that a ratio of a sedimentation rate of the red phosphor in the light-transmitting resin material with respect to that of the green phosphor ranges from 0.70 to 1.30.

12. The white light-emitting device according to any one of claims 1 to 11, wherein densities of the blue phosphor, the green phosphor and the red phosphor range all from 3.0 to 5.0 g/cm$^3$.

13. The white light-emitting device according to any one of claims 1 to 12, wherein the phosphor forms a phosphor layer, and a distance between the phosphor layer and the semiconductor light-emitting element ranges from 0.1 to 500 mm.

14. The white light-emitting device according to claim 13, wherein a condensing lens is provided on a light exit surface side of the phosphor layer.

15. The white light-emitting device according to claim 13, wherein a light extraction layer is provided on a light exit surface side of the phosphor layer.

16. An illumination device, having the light-emitting device according to any one of claims 1 to 15.

**Patentansprüche**

1. Weißlicht-emittierende Vorrichtung vom Leuchtstoffumwandlungstyp umfassend ein lichtemittierendes Halbleiterelement, das Licht in einem nahen ultravioletten Wellenlängenbereich emittiert, und einen Leuchtstoff, der die Wellenlänge des durch das lichtemittierende Halbleiterelement emittierten Lichts zur Erzeugung von Weißlicht umwandelt, wobei
der Leuchtstoff einen blauen Leuchtstoff mit einer chemischen Zusammensetzung der folgenden Formel [1], einen grünen Leuchtstoff mit einer Emissionspeakwellenlänge von 535 nm oder größer und mindestens einen Typ eines roten Leuchtstoffs ausgewählt aus einem Eu-aktivierten Nitrid-Leuchtstoff und einem Eu-aktivierten Oxynitrid-Leuchtstoff einschließt, und
das durch die Weißlicht-emittierende Vorrichtung emittierte Weißlicht eine Farbtemperatur im Bereich von 1800 K bis 7000 K aufweist;

$$(Sr, Ca)_a Ba_b Eu_x (PO_4)_c X_d \qquad [1]$$

(In der allgemeinen Formel [1] ist X Cl, c, d und x sind Zahlen, die $2,7 \leq c \leq 3,3$, $0,9 \leq d \leq 1,1$ und $0,3 \leq x \leq 1,2$ erfüllen, und a und b erfüllen die Bedingungen a+b = 5-x und $0,12 \leq b/(a+b) \leq 0,4$ und (Sr, Ca) bedeutet, dass der Leuchtstoff entweder sowohl Sr als auch Ca oder Sr allein enthält.).

2. Weißlicht-emittierende Vorrichtung gemäß Anspruch 1, wobei die Lichtfarbe des durch die Weißlicht-emittierende Vorrichtung emittierten Weißlichts eine Abweichung duv von -0,0200 bis 0,0200 von einer Schwarzkörperstrahlungskurve aufweist, die durch JIS Z8725:1999 definiert ist.

3. Weißlicht-emittierende Vorrichtung gemäß Anspruch 1 oder 2, wobei der grüne Leuchtstoff eine Emissionspeakwellenlänge im Bereich von 535 bis 545 nm und eine Emissionspeak-Halbwertsbreite im Bereich von 55 bis 70 nm aufweist, der blaue Leuchtstoff eine Emissionspeakwellenlänge im Bereich von 450 bis 460 nm und einen I(490 nm)/I(Peak)-Wert, in dem I(Peak) eine Intensität der Emissionspeakwellenlänge bezeichnet und I(490 nm) eine Intensität bei der Wellenlänge 490 nm in einem Emissionsspektrum des blauen Leuchtstoffs bei Anregung mit Licht einer Wellenlänge von 410 nm bezeichnet, von 0,55 bis 0,65 reicht.

4. Weißlicht-emittierende Vorrichtung gemäß irgendeinem der Ansprüche 1 bis 3, wobei der grüne Leuchtstoff eine Emissionspeakwellenlänge im Bereich von 535 bis 545 nm und eine Emissionspeak-Halbwertsbreite im Bereich von 55 bis 70 nm aufweist und der blaue Leuchtstoff eine Zusammensetzung aufweist, die durch die allgemeine Formel [1] dargestellt wird, wobei der b/(a+b)-Wert im Bereich von 0,15 bis 0,20 liegt, worin das Metallelement im Wesentlichen Sr, Eu und Ba allein ist.

5. Weißlicht-emittierende Vorrichtung gemäß irgendeinem der Ansprüche 1 bis 4, wobei der grüne Leuchtstoff einen Euaktivierten Oxynitrid-Leuchtstoff einschließt.

6. Weißlicht-emittierende Vorrichtung gemäß irgendeinem der Ansprüche 1 bis 5, wobei der rote Leuchtstoff einen CASON-Leuchtstoff einschließt.

7. Weißlicht-emittierende Vorrichtung gemäß irgendeinem der Ansprüche 1 bis 6, wobei ein allgemeiner Farbwiedergabeindex Ra und ein spezieller Farbwiedergabeindex R12 jeweils 90 oder größer sind.

8. Weißlicht-emittierende Vorrichtung gemäß Anspruch 1, wobei der grüne Leuchtstoff ein Eu-aktivierter Oxynitrid-Leuchtstoff ist und der blaue Leuchtstoff eine Zusammensetzung aufweist, die durch die allgemeine Formel [1] dargestellt wird, wobei der b/(a+b)-Wert im Bereich von 0,16 bis 0,40 liegt, worin das Metallelement im Wesentlichen Sr, Eu und Ba allein ist.

9. Weißlicht-emittierende Vorrichtung gemäß Anspruch 8, wobei der Wert von x in der Formel [1] von 0,3 bis weniger als 0,65 reicht.

10. Weißlicht-emittierende Vorrichtung gemäß irgendeinem der Ansprüche 1 bis 9, wobei der blaue Leuchtstoff, der grüne Leuchtstoff und der rote Leuchtstoff in einem lichtdurchlässigen Harzmaterial dispergiert und danach in der Weißlicht-emittierenden Vorrichtung eingekapselt werden, so dass ein Verhältnis einer Sedimentationsgeschwindigkeit des blauen Leuchtstoffs in dem lichtdurchlässigen Harzmaterial bezogen auf die des grünen Leuchtstoffs von 0,70 bis 1,30 reicht.

**EP 2 535 392 B1**

**11.** Weißlicht-emittierende Vorrichtung gemäß irgendeinem der Ansprüche 1 bis 10, wobei der blaue Leuchtstoff, der grüne Leuchtstoff und der rote Leuchtstoff in einem lichtdurchlässigen Harzmaterial dispergiert und danach in der Weißlicht-emittierenden Vorrichtung eingekapselt werden, so dass ein Verhältnis einer Sedimentationsgeschwindigkeit des roten Leuchtstoffs in dem lichtdurchlässigen Harzmaterial bezogen auf die des grünen Leuchtstoffs von 0,70 bis 1,30 reicht.

**12.** Weißlicht-emittierende Vorrichtung gemäß irgendeinem der Ansprüche 1 bis 11, wobei die Dichten des blauen Leuchtstoffs, des grünen Leuchtstoffs und des roten Leuchtstoffs alle von 3,0 bis 5,0 g/cm$^3$ reichen.

**13.** Weißlicht-emittierende Vorrichtung gemäß irgendeinem der Ansprüche 1 bis 12, wobei der Leuchtstoff eine Leuchtstoffschicht bildet und ein Abstand zwischen der Leuchtstoffschicht und dem lichtemittierenden Halbleiterelement von 0,1 bis 500 mm reicht.

**14.** Weißlicht-emittierende Vorrichtung gemäß Anspruch 13, wobei eine Kondensorlinse auf einer Lichtaustrittsoberflächenseite der Leuchtstoffschicht vorgesehen ist.

**15.** Weißlicht-emittierende Vorrichtung gemäß Anspruch 13, wobei eine Lichtauskopplungsschicht auf einer Lichtaustrittsoberflächenseite der Leuchtstoffschicht vorgesehen ist.

**16.** Beleuchtungsvorrichtung, die die lichtemittierende Vorrichtung gemäß irgendeinem der Ansprüche 1 bis 15 aufweist.


**Revendications**

**1.** Un dispositif émetteur de lumière blanche de type conversion de phosphore comprenant un élément semi-conducteur émetteur de lumière qui émet de la lumière dans une région de longueur d'onde proche ultraviolet, et un phosphore qui convertit la longueur d'onde de la lumière émise par l'élément semi-conducteur émetteur de lumière pour générer de la lumière blanche, dans lequel
le phosphore comprend un phosphore bleu ayant une composition chimique de formule [1] ci-dessous, un phosphore vert ayant une longueur d'onde maximale d'émission de 535 nm ou supérieure, et au moins un type de phosphore rouge choisi parmi un nitrure de phosphore activé par Eu et un oxynitrure de phosphore activé par Eu, et
la lumière blanche émise par le dispositif émetteur de lumière blanche a une température de couleur allant de 1800 K à 7000 K;

$$(Sr, Ca)_a Ba_b Eu_x (PO_4)_c X_d \qquad [1]$$

(dans la formule générale [1], X est Cl; c, d et x sont des nombres satisfaisant $2,7 \leq c \leq 3,3$, $0,9 \leq d \leq 1,1$ et $0,3 \leq x \leq 1,2$; et a et b satisfont les conditions $a+b = 5-x$ et $0,12 \leq b/(a+b) \leq 0,4$ et (Sr, Ca) signifie que le phosphore contient soit à la fois Sr et Ca ou Sr tout seul.).

**2.** Le dispositif émetteur de lumière blanche selon la revendication 1, dans lequel la couleur de lumière de la lumière blanche émise par le dispositif émetteur de lumière blanche présente une déviation duv de -0,0200 à 0,0200 d'un locus de rayonnement du corps noir tel que défini par JIS Z8725:1999.

**3.** Le dispositif émetteur de lumière blanche selon la revendication 1 ou 2, dans lequel le phosphore vert a une longueur d'onde maximale d'émission allant de 535 à 545 nm et une demi-largeur de pic d'émission allant de 55 à 70 nm, le phosphore bleu a une longueur d'onde maximale d'émission allant de 450 à 460 nm, et une valeur de I(490 nm)/I(pic), dans laquelle I(pic) dénote une intensité de la longueur d'onde maximale d'émission et I(490 nm) dénote une intensité à une longueur d'onde de 490 nm dans un spectre d'émission du phosphore bleu par excitation avec une lumière de longueur d'onde 410 nm, va de 0,55 à 0,65.

**4.** Le dispositif émetteur de lumière blanche selon l'une quelconque des revendications 1 à 3, dans lequel le phosphore vert a une longueur d'onde maximale d'émission allant de 535 nm à 545 nm et une demi-largeur de pic d'émission allant de 55 à 70 nm, et le phosphore bleu ayant une composition qui est représentée par la formule générale [1] avec la valeur b/(a+b) allant de 0,15 à 0,20, dans laquelle l'élément métallique est essentiellement Sr, Eu et Ba tout seul.

**5.** Le dispositif émetteur de lumière blanche selon l'une quelconque des revendications 1 à 4, dans lequel le phosphore

46

vert comprend un oxynitrure de phosphore activé par Eu.

6. Le dispositif émetteur de lumière blanche selon l'une quelconque des revendications 1 à 5, dans lequel le phosphore rouge comprend un phosphore CASON ($Ca_{1-x}Al_{1-x}Si_{1+x}N_{3-x}O_x$:Eu tel que décrit dans JP-A-2007-231245).

7. Le dispositif émetteur de lumière blanche selon l'une quelconque des revendications 1 à 6, dans lequel un indice de rendu des couleurs général Ra et un indice de rendu de couleurs spécial R12 sont tous deux de 90 ou supérieurs.

8. Le dispositif émetteur de lumière blanche selon la revendication 1, dans lequel le phosphore vert est un oxynitrure de phosphore activé par Eu, et le phosphore bleu a une composition qui est représentée par la formule générale [1] avec la valeur b/(a+b) allant de 0,16 à 0,40, dans laquelle l'élément métallique est essentiellement Sr, Eu et Ba tout seul.

9. Le dispositif émetteur de lumière blanche selon la revendication 8, dans lequel la valeur de x dans la formule [1] va de 0,3 à moins que 0,65.

10. Le dispositif émetteur de lumière blanche selon l'une quelconque des revendications 1 à 9, dans lequel le phosphore bleu, le phosphore vert et le phosphore rouge sont dispersés dans un matériau de résine transmettant la lumière et sont ensuite encapsulés dans le dispositif émetteur de lumière blanche, tel que le rapport d'une vitesse de sédimentation du phosphore bleu dans le matériau de résine transmettant la lumière à celui du phosphore vert va de 0,70 à 1, 30.

11. Le dispositif émetteur de lumière blanche selon l'une quelconque des revendications 1 à 10, dans lequel le phosphore bleu, le phosphore vert et le phosphore rouge sont dispersés dans un matériau de résine transmettant la lumière et sont ensuite encapsulés dans le dispositif émetteur de lumière blanche, tel qu'un rapport d'une vitesse de sédimentation du phosphore rouge dans le matériau de résine transmettant la lumière à celui du phosphore vert va de 0,70 à 1,30.

12. Le dispositif émetteur de lumière blanche selon l'une quelconque des revendications 1 à 11, dans lequel les densités du phosphore bleu, du phosphore vert et du phosphore rouge vont toutes de 3,0 à 5,0 g/cm$^3$.

13. Le dispositif émetteur de lumière blanche selon l'une quelconque des revendications 1 à 12, dans lequel le phosphore forme une couche de phosphore, et une distance entre la couche de phosphore et l'élément semi-conducteur émetteur de lumière va de 0,1 à 500 mm.

14. Le dispositif émetteur de lumière blanche selon la revendication 13, dans lequel une lentille de condensation est fournie sur un côté de la surface de sortie de la lumière de la couche de phosphore.

15. Le dispositif émetteur de lumière blanche selon la revendication 13, dans lequel une couche d'extraction de lumière est fournie sur un côté de la surface de sortie de la lumière de la couche de phosphore.

16. Un dispositif d'éclairage, ayant le dispositif émetteur de lumière selon l'une quelconque des revendications 1 à 15.

Fig. 1

Fig. 2

Fig. 3

Fig. 4

Fig. 5

Fig. 6

Fig. 7

Fig. 8

Fig. 9

Fig. 10

Fig. 11

Fig. 12

(a) a surface package type

(b) a bullet type

(c) reflective type

Fig. 13

Fig. 14

Fig. 15

Fig. 16

Fig. 17

Fig. 18

Fig. 19

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004253747 A
- WO 2009141982 A
- JP 2006008721 A
- JP 2008007751 A
- JP 2007231245 A
- WO 2007091687 A
- JP 2005255895 A
- WO 2007088966 A
- JP 2004266201 A
- JP 2009030042 A

- JP 6260681 A
- JP 3921545 B
- JP 2008274254 A
- WO 2009072043 A
- WO 2007105631 A
- JP 2008038081 A
- WO 2008096300 A
- US 7524437 B
- JP 2009023922 A
- WO 200709187 A